# EUROPEAN PATENT APPLICATION

(11) **EP 4 669 043 A1**
(43) Date of publication of application: **24.12.2025**
(21) Application number: 23948949.5
(22) Date of filing: 13.09.2023
(51) Int. Cl.: H05K 7/20, H01M 50/574, H01M 50/20, H01M 10/653

(54) **POWER DISTRIBUTION APPARATUS, BATTERY, AND ELECTRIC DEVICE**

(30) Priority: 17.08.2023 CN 202311041120
(71) Applicant: Contemporary Amperex Technology Co., Limited, Ningde, Fujian 352100 (CN)
(72) Inventor: LI, Yuanxin, Ningde, Fujian 352100 (CN); WANG, Chong, Ningde, Fujian 352100 (CN); ZHENG, Chenling, Ningde, Fujian 352100 (CN)
(74) Representative: Gong, Jinping
(86) International application number: PCT/CN2023/118555
(87) International publication number: WO 2025/035524

(57) **Abstract**

A power distribution apparatus (30), a battery (1), and a power consuming device are provided. The power distribution apparatus (30) includes an electrical component (31) and an insulating heat conduction member (32). One side of the insulating heat conduction member (32) is connected to at least a part of the electrical component (31), the other side of the insulating heat conduction member (32) is configured to be connected to a heat exchange member (40), and the insulating heat conduction member (32) is configured to transfer heat from the electrical component (31) to the heat exchange member (40). According to the power distribution apparatus (30), heat is conducted between the electrical component (31) and the heat exchange member (40) through the insulating heat conduction member (32), thereby enhancing the heat dissipation performance and the heat dissipation efficiency of the power distribution apparatus (30) for the electrical component (31), reducing the risk of thermal failure of the electrical component (31), and prolonging the service life of the electrical component (31) and the power distribution apparatus (30).

## Description

### CROSS-REFERENCE TO RELATED APPLICATIONS

The present application claims priority to Chinese Patent Application No. 202311041120.1, filed with the China National Intellectual Property Administration on August 17, 2023 and entitled "POWER DISTRIBUTION APPARATUS, BATTERY, AND POWER CONSUMING DEVICE", which is incorporated herein by reference in its entirety.

### TECHNICAL FIELD

Embodiments of this application relates to the field of batteries, and in particular, to a power distribution apparatus, a battery, and a power consuming device.

### BACKGROUND

In batteries, a power distribution apparatus is a control unit that distributes battery energy, and particularly, can perform high-voltage distribution for the batteries. In some cases, an electrical component is disposed inside the power distribution apparatus. The electrical component generates a large amount of heat during the operation of the power distribution apparatus, and as a result the electrical component is prone to thermal failure.

### SUMMARY

Embodiments of this application provide a power distribution apparatus, a battery, and a power consuming device, to solve the problem that an electrical component generates a large amount of heat during operation of a power distribution apparatus, and as a result the electrical component is prone to thermal failure.

To achieve the foregoing objective, technical solutions used in the embodiments of this application are as follows:

According to a first aspect, a power distribution apparatus is provided, including:
an electrical component; and
an insulating heat conduction member, where one side of the insulating heat conduction member is connected to at least a part of the electrical component, the other side of the insulating heat conduction member is configured to be connected to a heat exchange member, and the insulating heat conduction member is configured to transfer heat from the electrical component to the heat exchange member.

In the power distribution apparatus provided in the embodiments of this application, the insulating heat conduction member may be connected to the electrical component with thermal insulation, and the insulating heat conduction member may be connected to an external heat exchange member with thermal insulation. Based on this, in one aspect, through the insulating performance of the insulating heat conduction member, the insulation between the electrical component and the heat exchange member by the insulating heat conduction member can be ensured, so that a short circuit among the electrical component, the insulating heat conduction member, and the heat exchange member can be basically avoided, thereby effectively reducing a risk of high-voltage short-circuit arcing among the electrical component, the insulating heat conduction member, and the heat exchange member. In another aspect, heat exchange and heat conduction between the electrical component and the heat exchange member through the insulating heat conduction member can be facilitated, especially, the conduction of heat generated by the electrical component to the heat exchange member through the insulating heat conduction member can be facilitated, thereby dissipating and conducting the heat generated by the electrical component outside the power distribution apparatus. In this way, the heat dissipation performance and the heat dissipation efficiency of the power distribution apparatus for the electrical component can be effectively ensured and enhanced, thereby effectively reducing a risk of thermal failure of the electrical component, and effectively ensuring and prolonging the service life of the electrical component and the power distribution apparatus.

In some embodiments, the electrical component includes a sheet conductive structure. The conductive structure is provided with a heat conduction surface. The heat conduction surface is connected to the insulating heat conduction member.

Through the use of the foregoing solution, the heat conduction surface of the conductive structure of the electrical component is connected to the insulating heat conduction member, so that in one aspect, based on the insulation characteristic of the insulating heat conduction member, the conductive structure can be insulated from the insulating heat conduction member, thereby basically avoiding a short circuit between the conductive structure and the insulating heat conduction member, and reducing a risk of high-voltage short circuit arcing between the conductive structure and the insulating heat conduction member. In another aspect, the conductive structure of the electrical component that generates a large amount of heat during operation can be directly thermally attached to the insulating heat conduction member through the heat conduction surface. Based on this, a heat conduction contact area between the conductive structure and the insulating heat conduction member can be ensured and increased, so that a large amount of heat generated by the conductive structure can be reliably and effectively conducted to the heat exchange member through the insulating heat conduction member. In this way, the heat dissipation performance and the heat dissipation efficiency of the power distribution apparatus for the electrical component can be effectively ensured and enhanced, thereby effectively reducing a risk of thermal failure of the electrical component, and effectively ensuring and prolonging the service life of the electrical component and the power distribution apparatus.

In some embodiments, the power distribution apparatus includes a case, configured to mount the electrical component.

The conductive structure includes a first conductive portion, a second conductive portion, and a third conductive portion. The second conductive portion is disposed on a side of the case that faces the insulating heat conduction member. The heat conduction surface is provided on a side of the second conductive portion that faces the insulating heat conduction member.

The first conductive portion and the third conductive portion are respectively connected to different sides of the second conductive portion, and are both bent toward a side close to the case. The first conductive portion is connected to a corresponding electrical component. The third conductive portion is configured to be connected to an electrical element.

Through the use of the foregoing solution, the electrical component may be mounted through the case, so that the electrical component is protected, and a mounting position and a mounting state of the electrical component with respect to the case are stable and secure. Based on this, the service life of the electrical component can be ensured and prolonged. In addition, the electrical component and the insulating heat conduction member can be precisely and stably aligned, so that the electrical component can precisely and reliably establish a thermal insulation connection relationship with the insulating heat conduction member. In addition, a mutual stable position and state between the electrical component and another electrical element can be facilitated, so that the electrical component can stably and reliably establish an electrical connection relationship with another electrical element.

Through the use of the foregoing solution, through the conductive structure, especially through the first conductive portion, the second conductive portion, and the third conductive portion that are sequentially bent and connected, the corresponding electrical component can be conveniently and reliably electrically connected to the corresponding electrical element. Based on this, the second conductive portion may be further disposed on the side of the case that faces the insulating heat conduction member, and the heat conduction surface is disposed on the side of the second conductive portion that faces the insulating heat conduction member, so that the conductive structure can be directly connected to the insulating heat conduction member with thermal insulation through the heat conduction surface of the second conductive portion. Based on this, the obstruction of a heat conduction path between the conductive structure and the insulating heat conduction member by the case can be reduced, and the heat conduction contact area between the conductive structure and the insulating heat conduction member can be ensured and increased. In this way, the heat conduction between the conductive structure and the insulating heat conduction member can be ensured and enhanced, a large amount of heat generated by the conductive structure can be quickly conducted out reliably and effectively through the insulating heat conduction member, and the heat dissipation performance and the heat dissipation efficiency of the power distribution apparatus for the electrical component can be ensured and enhanced.

In some embodiments, the case is provided with at least one accommodating cavity.

At least one electrical component is a relay. The relay is fixedly mounted in the accommodating cavity. The relay includes a switch unit. At least a portion of an outer wall of the switch unit is exposed from the accommodating cavity. A wall of the accommodating cavity is connected to the relay to fix the relay in the accommodating cavity.

The conductive structure of the relay is disposed outside the accommodating cavity. The second conductive portion of the relay is disposed on an outer side of the accommodating cavity that is close to the insulating heat conduction member.

Through the use of the foregoing solution, the relay may be accommodated in the accommodating cavity of the case, and the wall of the accommodating cavity is connected to the relay, thereby fixing the relay in the accommodating cavity. Based on this, for the relay fixedly mounted in the accommodating cavity, at least a portion of the outer wall of the switch unit of the relay may be exposed from the accommodating cavity, so that the wall of the accommodating cavity is used in place of a casing structure of the relay to protect the relay. Based on this, based on ensuring that the case can accommodate, limit, fix, and protect the relay, the casing structure of the relay can be effectively omitted. In this way, the overall layout of the case and the relay is compact, the power distribution apparatus featuring integration, miniaturization, lightweight, and simplicity can be formed, the design margins, space waste, and an occupied space of the power distribution apparatus can be effectively reduced, the mass of the power distribution apparatus can be effectively reduced, and the production costs of the power distribution apparatus can be reduced.

Through the use of the foregoing solution, the conductive structure of the relay may be disposed outside the accommodating cavity, so that the conductive structure can electrically connect the relay to another electrical element without additionally occupying an internal space of the accommodating cavity. Based on this, the design margins and space waste between the case and the relay can be reduced, the assembly and cooperation of the case, the relay, the conductive structure of the relay, the electrical element connected to the conductive structure of the relay, and the like can be facilitated, and the conductive structure can electrically connect the relay to another electrical element conveniently and reliably. Based on this, the second conductive portion of the relay may further be disposed on the outer side of the accommodating cavity that is close to the insulating heat conduction member, so that the second conductive portion of the relay may be exposed from the outer side of the accommodating cavity that is close to the insulating heat conduction member, making it convenient for the conductive structure of the relay to be directly connected to the insulating heat conduction member with thermal insulation through the second conductive portion. In this way, the obstruction of the heat conduction path between the conductive structure of the relay and the insulating heat conduction member by the wall of the accommodating cavity can be reduced, the heat conduction contact area between the conductive structure of the relay and the insulating heat conduction member can be increased, the heat conduction between the relay and the insulating heat conduction member can be enhanced, heat generated by the relay and the conductive structure of the relay can be quickly conducted out reliably and effectively through the insulating heat conduction member, the heat dissipation performance and the heat dissipation efficiency of the power distribution apparatus for the relay can be enhanced, and a risk of thermal failure of the relay can be reduced.

In some embodiments, the power distribution apparatus includes a base, configured to be disposed on the heat exchange member.

The insulating heat conduction member is mounted on the base. A surface of the insulating heat conduction member that faces away from the electrical component is exposed from the base and is connected to the heat exchange member.

Through the use of the foregoing solution, the insulating heat conduction member may be mounted and fixed through the base, so that a mounting position and a mounting state of the insulating heat conduction member with respect to the base are stable and secure, the insulating heat conduction member and the electrical component can be precisely and stably aligned, a and the insulating heat conduction member can precisely and reliably establish a thermal insulation connection relationship with the electrical component. Based on this, a side of the insulating heat conduction member that faces the electrical component is connected to the electrical component with thermal insulation, and a surface of the insulating heat conduction member that faces away from the electrical component is exposed from the base, and is thermally connected to heat exchange member. Therefore, the insulating heat conduction member can be directly connected with thermal insulation between the electrical component and the heat exchange member, the obstruction of a heat conduction path of the insulating heat conduction member by the base can be reduced, and the heat conduction of the insulating heat conduction member between the electrical component and the heat exchange member can be ensured and enhanced.

In some embodiments, the insulating heat conduction member is embedded in the base.

Through the use of the foregoing solution, based on the foregoing embodiment, the insulating heat conduction member may be at least partially embedded in the base. Based on this, in one aspect, the insulating heat conduction member can at least partially share a space with the base, so that an occupied space of the insulating heat conduction member and the base can be reduced. In another aspect, the insulating heat conduction member may be directly connected between the electrical component and the heat exchange member with thermal insulation through the base, so that the obstruction of a heat conduction path of the insulating heat conduction member by the base can be reduced, and the heat conduction of the insulating heat conduction member between the electrical component and the heat exchange member can be ensured and enhanced.

In some embodiments, a first limiting structure is disposed on a side of the base that faces the electrical component, and is configured to limit and mount a portion of the electrical component that is connected to the insulating heat conduction member.

Through the use of the foregoing solution, the first limiting structure may be disposed on the base, so that a part of the electrical component that is configured to be thermally connected to the insulating heat conduction member is limited and mounted in the first limiting structure, and is connected to a surface at a position of the insulating heat conduction member that corresponds to the first limiting structure with thermal insulation. Based on this, the part of the electrical component that is configured to be thermally connected to the insulating heat conduction member may be limited and positioned through the first limiting structure of the base, so that quick and precise alignment and cooperation of the electrical component and the base can be facilitated, the electrical component can be precisely aligned with the insulating heat conduction member mounted in the base, relative positions and relative states of the electrical component and the insulating heat conduction member can be stabilized, the electrical component and the insulating heat conduction member can be precisely and reliably connected with thermal insulation, and the heat conduction between the electrical component and the insulating heat conduction member can be ensured.

In some embodiments, the first limiting structure is a hole structure. The first limiting structure is in communication with a surface of the insulating heat conduction member.

Through the use of the foregoing solution, in a case that a surface of the insulating heat conduction member that faces the electrical component is embedded in the base, the first limiting structure of the hole structure is provided in the base, and the first limiting structure is in communication with the surface of the insulating heat conduction member, so that the part of the electrical component that is configured to be thermally connected to the insulating heat conduction member can be inserted and limited in the first limiting structure, and is connected to the surface of the insulating heat conduction member that corresponds to the first limiting structure with thermal insulation. Based on this, the part of the electrical component that is configured to be thermally connected to the insulating heat conduction member may be limited and positioned by the first limiting structure, so that the electrical component can be precisely aligned with the insulating heat conduction member, and is connected to the insulating heat conduction member with thermal insulation tightly and reliably. Based on this, it can further be ensured that a part of the electrical component can deeply enter the base, and can be directly connected to the insulating heat conduction member with thermal insulation through the base, so that the obstruction of a heat conduction path between the electrical component and the insulating heat conduction member by the base can be reduced, and the heat conduction between the insulating heat conduction member and the electrical component can be enhanced. In addition, a combined occupied space of the electrical component, the base, and the insulating heat conduction member can be reduced.

In some embodiments, a second limiting structure is disposed on a side of the base that faces away from the electrical component, and is configured to limit and mount the insulating heat conduction member.

Through the use of the foregoing solution, the second limiting structure may be disposed on the side of the base that faces away from the electrical component, so that the insulating heat conduction member is limited and mounted in the second limiting structure. Based on this, the insulating heat conduction member may be limited and accommodated through the second limiting structure of the base, so that quick and precise assembly of the insulating heat conduction member and the base can be facilitated, the insulating heat conduction member can be precisely aligned with the electrical component to be thermally connected to the insulating heat conduction member, and the insulating heat conduction member can precisely, stably, and reliably achieve heat conduction.

In some embodiments, the second limiting structure is a groove structure.

Through the use of the foregoing solution, the second limiting structure of the groove structure may be disposed in the base, so that the insulating heat conduction member is embedded in the second limiting structure. Based on this, the insulating heat conduction member may be limited and positioned by the second limiting structure, so that the insulating heat conduction member can be precisely aligned with the base and the electrical components, and the insulating heat conduction member is connected to the electrical components with thermal insulation tightly and reliably. Based on this, it can further be ensured that at least a part of the insulating heat conduction member can deeply enter and be embedded in the base, and can be directly connected to the electrical component with thermal insulation through the base, so that the obstruction of a heat conduction path between the electrical component and the insulating heat conduction member by the base can be reduced, and the heat conduction between the insulating heat conduction member and the electrical component can be enhanced. In addition, a combined occupied space of the electrical component, the base, and the insulating heat conduction member can be reduced.

In some embodiments, a side surface of the insulating heat conduction member that faces away from the electrical component protrudes from a groove opening of the second limiting structure.

Through the use of the foregoing solution, in a case that the insulating heat conduction member is embedded in the second limiting structure, the side surface of the insulating heat conduction member that faces away from the electrical component may protrude from the groove opening of the second limiting structure, so that the side surface of the insulating heat conduction member that faces away from the electrical component can be exposed from the second limiting structure. Based on this, the side surface of the insulating heat conduction member that faces away from the electrical component may be directly thermally connected to the heat exchange member, so that the obstruction of a heat conduction path between the insulating heat conduction member and the heat exchange member by the base can be reduced, and the heat conduction between the insulating heat conduction member and the heat exchange member can be ensured and enhanced. In addition, because the side surface of the insulating heat conduction member that faces away from the electrical component protrudes from the groove opening of the second limiting structure, a dimension of the insulating heat conduction member in a groove depth direction of the second limiting structure is greater than a groove depth of the second limiting structure. In this way, even if the dimension of the insulating heat conduction member in the groove depth direction of the second limiting structure or the groove depth of the second limiting structure has a processing error, when the insulating heat conduction member is embedded in the second limiting structure, it can be basically ensured that the side surface of the insulating heat conduction member that faces away from the electrical component can be exposed from the second limiting structure, and is directly thermally connected to the heat exchange member. Therefore, based on the arrangement in this embodiment, particular processing errors can be accommodated and tolerated, and the requirement of cooperation precision between the insulating heat conduction member and the second limiting structure in the groove depth direction of the second limiting structure can be lowered, thereby facilitating the processing and assembly of the insulating heat conduction member and the base.

In some embodiments, a side surface of the insulating heat conduction member that faces away from the electrical component is flush with a groove opening of the second limiting structure.

Through the use of the foregoing solution, in a case that the insulating heat conduction member is embedded in the second limiting structure, the side surface of the insulating heat conduction member that faces away from the electrical component may be flush with the groove opening of the second limiting structure, so that the side surface of the insulating heat conduction member that faces away from the electrical component can be exposed from the second limiting structure. Based on this, the side surface of the insulating heat conduction member that faces away from the electrical component may be directly thermally connected to the heat exchange member, so that the obstruction of a heat conduction path between the insulating heat conduction member and the heat exchange member by the base can be reduced, and the heat conduction between the insulating heat conduction member and the heat exchange member can be ensured and enhanced.

In some embodiments, a direct current breakdown strength of the insulating heat conduction member ranges from 15 kilovolt/millimeter (Kv/mm) to 17 Kv/mm.

Through the use of the foregoing solution, the direct current breakdown strength of the insulating heat conduction member ranges from 15 Kv/mm to 17 Kv/mm, so that the insulating heat conduction member can have a better voltage withstand capability with respect to a conventional insulating thermally conductive adhesive. Based on this, based on reliable heat exchange and heat conduction of the insulating heat conduction member between the electrical component and the heat exchange member, a risk of high-voltage breakdown of the insulating heat conduction member during the operation of the electrical component can be effectively reduced, thereby effectively ensuring and prolonging the service life of the insulating heat conduction member, effectively reducing a risk of thermal failure of the electrical component, and effectively ensuring and enhancing the service life and the use safety of the power distribution apparatus.

In some embodiments, the direct current breakdown strength of the insulating heat conduction member ranges from 15.1 Kv/mm to 16.6 Kv/mm.

Through the use of the foregoing solution, the direct current breakdown strength of the insulating heat conduction member ranges from 15.1 Kv/mm to 16.6 Kv/mm, so that in one aspect, the insulating heat conduction member can have a better voltage withstand capability compared with a conventional insulating thermally conductive adhesive, so that a risk of high-voltage breakdown of the insulating heat conduction member during the operation of the electrical component can be effectively reduced, thereby effectively ensuring and prolonging the service life of the insulating heat conduction member, effectively reducing a risk of thermal failure of the electrical component, and effectively ensuring and enhancing the service life and the use safety of the power distribution apparatus. In another aspect, the requirement of the voltage withstand capability of the insulating heat conduction member can be correspondingly measured, thereby effectively reducing the manufacturing difficulty and costs of the insulating heat conduction member, and effectively reducing the costs of the power distribution apparatus.

In some embodiments, the insulating heat conduction member is a phase-change material member.

Through the use of the foregoing solution, the insulating heat conduction member may be a phase-change material member, so that the insulating heat conduction member can change a substance state and absorb or release a large amount of latent heat based on a phase-change characteristic of a phase-change material as the temperature remains unchanged. Based on this, the heat conduction performance and the heat dissipation performance of the insulating heat conduction member can be effectively ensured and enhanced, thereby effectively ensuring and enhancing the heat dissipation performance and the heat dissipation efficiency of the power distribution apparatus for the electrical component, effectively reducing a risk of thermal failure of the electrical component, and effectively ensuring and prolonging the service life of the electrical component and the power distribution apparatus.

In some embodiments, the insulating heat conduction member is a ceramic member.

Through the use of the foregoing solution, the insulating heat conduction member is a ceramic member, so that in one aspect, the heat conduction performance and the heat dissipation performance of the insulating heat conduction member can be effectively enhanced, thereby effectively enhancing the heat dissipation performance and the heat dissipation efficiency of the power distribution apparatus for the electrical component, effectively reducing a risk of thermal failure of the electrical component, and effectively ensuring and prolonging the service life of the electrical component and the power distribution apparatus. In another aspect, the insulating heat conduction member can have a better voltage withstand capability compared with a conventional insulating thermally conductive adhesive, so that a risk of high-voltage breakdown of the insulating heat conduction member during the operation of the electrical component can be effectively reduced, thereby effectively ensuring and prolonging the service life of the insulating heat conduction member, and effectively ensuring and enhancing the service life and the use safety of the power distribution apparatus.

In some embodiments, the insulating heat conduction member is at least one selected from the group consisting of aluminum oxide ceramic, aluminum nitride ceramic, and silicon nitride ceramic.

Through the use of the foregoing solution, the insulating heat conduction member may be at least one selected from the group consisting of aluminum oxide ceramic, aluminum nitride ceramic, and silicon nitride ceramic, so that the insulating heat conduction member has excellent performance such as electrical insulativity, heat conductivity, chemical resistance, abrasive resistance, and low thermal expansibility, thereby enhancing the use performance and the service life of the insulating heat conduction member.

In some embodiments, at least two electrical components are provided. One insulating heat conduction member is provided. All the electrical components are thermally connected to the insulating heat conduction member.

Through the use of the foregoing solution, the at least two electrical components may all be thermally connected to the insulating heat conduction member, so that the insulating heat conduction member can achieve heat conduction on the at least two electrical components. Based on this, in one aspect, an arrangement area of the insulating heat conduction member can be increased, and the heat conduction of the insulating heat conduction member for the electrical components can be ensured and enhanced, thereby ensuring and enhancing the heat dissipation performance and the heat dissipation efficiency of the power distribution apparatus for the electrical component, reducing a risk of thermal failure of the electrical component, and ensuring and prolonging the service life of the electrical component and the power distribution apparatus. In another aspect, an arrangement quantity of the insulating heat conduction members can be reduced, so that the assembly of the insulating heat conduction member is simplified, thereby ensuring and enhancing the assembly convenience and the assembly efficiency of the power distribution apparatus.

In some embodiments, the insulating heat conduction member is disposed in a one-to-one correspondence with the electrical component.

Through the use of the foregoing solution, the insulating heat conduction member and the electrical component may be disposed in a one-to-one correspondence, so that the insulating heat conduction members can be connected in a one-to-one correspondence to the electrical components with thermal insulation, thereby enabling the insulating heat conduction members to achieve heat conduction for the electrical components in a one-to-one correspondence. Based on this, the heat conduction of the insulating heat conduction members for the electrical components can be respectively ensured, or even the dimensions and shape of a corresponding insulating heat conduction member can be designed in a targeted manner according to a heat conduction demand of an electrical component. In this way, the heat dissipation performance and the heat dissipation efficiency of the power distribution apparatus for the electrical component can be effectively ensured and enhanced, thereby reducing a risk of thermal failure of the electrical component, and ensuring and prolonging the service life of the electrical component and the power distribution apparatus. In addition, based on the arrangement in this embodiment, the total material consumption of the insulating heat conduction members can further be correspondingly reduced, thereby correspondingly reducing the overall costs of the insulating heat conduction members, and correspondingly reducing the costs of the power distribution apparatus

In some embodiments, the insulating heat conduction member is securely fastened to the electrical component by a fastening member.

Through the use of the foregoing solution, the electrical component and the insulating heat conduction member may be securely fastened together by the fastening member, thereby enhancing the connection strength and the connection tightness between the electrical component and the insulating heat conduction member. Based on this, the tightness and reliability of the thermal connection between the electrical component and the insulating heat conduction member can be enhanced, so that the insulating heat conduction member can reliably and effectively conduct heat generated by the electrical component to the heat exchange member. In this way, the heat dissipation performance and the heat dissipation efficiency of the power distribution apparatus for the electrical component can be effectively ensured and enhanced, thereby effectively reducing a risk of thermal failure of the electrical component, and effectively ensuring and prolonging the service life of the electrical component and the power distribution apparatus.

In some embodiments, the insulating heat conduction member is bonded to the electrical component by a thermally conductive adhesive.

Through the use of the foregoing solution, the electrical component and the insulating heat conduction member may be bonded together by the thermally conductive adhesive, thereby enhancing the connection strength and the connection tightness between the electrical component and the insulating heat conduction member. Based on this, the tightness and reliability of the thermal connection between the electrical component and the insulating heat conduction member can be enhanced, so that the insulating heat conduction member can reliably and effectively conduct heat generated by the electrical component to the heat exchange member. In this way, the heat dissipation performance and the heat dissipation efficiency of the power distribution apparatus for the electrical component can be effectively ensured and enhanced, thereby effectively reducing a risk of thermal failure of the electrical component, and effectively ensuring and prolonging the service life of the electrical component and the power distribution apparatus.

In some embodiments, the electrical component includes at least one selected from the group consisting of a relay, a current sensor, a fuse, a protection device, and a pre-charge resistor.

Through the use of the foregoing solution, the electrical component includes at least one selected from the group consisting of the relay, the current sensor, the fuse, the protection device, and the pre-charge resistor, so that it can be ensured that the electrical component includes an important element configured to perform high-voltage distribution on a battery in the power distribution apparatus, and it can be ensured that the electrical component is a main heat generation element. Based on this, in combination with a connection between the insulating heat conduction member and the electrical component with thermal insulation, the heat dissipation performance and the heat dissipation efficiency of the power distribution apparatus for the electrical components such as the relay, the current sensor, the fuse, the protection device, and the pre-charge resistor can be ensured and enhanced, thereby effectively reducing a risk of thermal failure of the electrical components such as the relay, the current sensor, the fuse, the protection device, and the pre-charge resistor, and ensuring and prolonging the service life of the electrical components such as the relay, the current sensor, the fuse, the protection device, and the pre-charge resistor.

In some embodiments, at least two electrical components are provided.

A gap between the electrical component and the electrical component disposed adjacent to the electrical component is a first gap. The electrical component is provided with a first connecting member. The first connecting member includes a first connecting portion configured to be detachably connected to an external connecting member. The first connecting portion is located outside all the first gaps of the corresponding electrical components.

Through the use of the foregoing solution, in a case that the gap between each electrical component and the electrical component disposed adjacent to the electrical component is defined as the first gap, the first connecting portion is disposed outside the first gap of the corresponding electrical component, so that in one aspect, the connection operation of the first connecting portion can be performed in a space outside the first gap of the corresponding electrical component, thereby ensuring and enhancing the operation convenience of connecting and disconnecting the first connecting portion. In another aspect, the first gap of the electrical component neither needs to provide an accommodating space for the first connecting portion nor needs to provide a connection operation space for the first connecting portion, so that the gap between the electrical component and the electrical component disposed adjacent to the electrical component can be reduced as required, thereby making the overall layout of the electrical components compact, and facilitating the formation of the power distribution apparatus featuring integration, compactness, and miniaturization.

According to a second aspect, a battery is provided. The battery includes the power distribution apparatus provided in the embodiments of this application.

According to a third aspect, a power consuming device is provided. The power consuming device includes the battery provided in the embodiments of this application.

### BRIEF DESCRIPTION OF THE DRAWINGS

In order to provide a clearer explanation of the technical solution of the embodiments of this application, a brief introduction will be given to the accompanying drawings required to describe the embodiments or existing technologies. It is evident that the accompanying drawings described below are only some embodiments of this application. For ordinary technical personnel in the art, other accompanying drawings can be obtained based on these drawings without any creative effort.
FIG. 1 is a schematic structural diagram of a vehicle according to some embodiments of this application;
FIG. 2 is a schematic exploded view of a battery according to some embodiments of this application;
FIG. 3 is a partial schematic structural diagram of a battery according to some embodiments of this application;
FIG. 4 is a schematic structural diagram of a power distribution apparatus according to some embodiments of this application;
FIG. 5 is a schematic exploded view 1 of the power distribution apparatus provided in FIG. 4;
FIG. 6 is a schematic exploded view 2 of the power distribution apparatus provided in FIG. 4;
FIG. 7 is a front view of the power distribution apparatus provided in FIG. 4;
FIG. 8 is a cross-sectional view along A-A provided in FIG. 7;
FIG. 9 is a schematic exploded view of a case, a relay, and a cover member according to some embodiments of this application;
FIG. 10 is a cross-sectional view of a power distribution apparatus according to some other embodiments of this application, where a side surface of an insulating heat conduction member that faces away from an electrical component is flush with a groove opening of a second limiting structure;
FIG. 11 is a schematic exploded view of electrical components, a base, and an insulating heat conduction member according to some other embodiments of this application, where the insulating heat conduction member is disposed in a one-to-one correspondence with the electrical component;
FIG. 12 is a cross-sectional view of a power distribution apparatus according to some other embodiments of this application, where an insulating heat conduction member is securely fastened to an electrical component by a fastening member;
FIG. 13 is a cross-sectional view of a power distribution apparatus according to some other embodiments of this application, where an insulating heat conduction member is bonded to an electrical component by a thermally conductive adhesive; and
FIG. 14 is a schematic exploded view of electrical components, a cover body, and a mating member according to some embodiments of this application.

Reference numerals in the drawings:
1-battery, 2-controller, 3-motor; 10-battery unit; 20-housing, 21-first part, 22-second part; 30-power distribution apparatus; 40-heat exchange member, 41-thermal management element;
31-electrical component, 311-conductive structure, 3111-heat conduction surface, 3112-first conductive portion, 3113-second conductive portion, 3114-third conductive portion; 312-relay, 3121-main positive relay, 3122-main negative relay, 3123-pre-charge relay, 3124-switch unit, 31241-iron core, 31242-coil, 31243-bracket; 3125-contact; 313-current sensor, 3131-shunt, 3132-Hall current sensor; 314-protection device, 3141-main protection device, 315-pre-charge resistor; 316-first gap, 317-first connecting member, 3171-first connecting portion; 32-insulating heat conduction member; 33-case, 331-accommodating cavity, 332-insulating structure; 34-base, 341-first limiting structure, 342-second limiting structure; 35-fastening member; 36-thermally conductive adhesive; 37-mating member, 371-mating port, 372-second connecting member, 3721-second connecting portion, 3722-conductive connecting portion; 38-cover body; 39-cover member, 391-snap-fit clip, 392-through hole.

### DETAILED DESCRIPTION

To make the technical problems solved by this application, the technical solutions, and the beneficial effects clear, this application is described below in detail with reference to the accompanying drawings and the embodiments. It should be understood that the specific embodiments described herein are merely used to explain this application but are not intended to limit this application.

It needs to be understood that, in the descriptions of the present disclosure, a direction or positional relationship indicated by terms such as "length", "width", "up", "down", "front", "back", "left", "right", "vertical", "horizontal", "top", "bottom", "in", and "out" is a direction or positional relationship based on illustrations in the drawings, and is merely intended for ease or brevity of description of the present disclosure, but does not necessarily mean or imply that the indicated device or element is provided in the specified direction or constructed or operated in the specified direction. Therefore, such terms are not to be understood as a limitation on the present disclosure.

In addition, the terms "first" and "second" are merely intended for a purpose of description, and shall not be understood as indicating or implying relative significance or implicitly indicating a quantity of indicated technical features. Therefore, features defining "first" and "second" can explicitly or implicitly include one or at least two of the features. In the descriptions of the present disclosure, unless clearly and specifically defined otherwise, "at least two" means two or more than two.

In the present disclosure, unless otherwise clearly specified and defined, terms such as "mounting", "interconnection", "connection", and "fixing" shall be understood in a broad sense, for example, may be a fixed connection, a detachable connection, an integral connection, a mechanical connection, an electrical connection, a direct connection, an indirect connection by using an intermediate medium, communication between interiors of two elements, or interaction between two elements. A person of ordinary skill in the art may understand specific meanings of the foregoing terms in this application according to specific cases.

In batteries, a power distribution apparatus is a control unit that distributes battery energy, and particularly, can perform high-voltage distribution for the batteries. In some cases, an electrical component is disposed inside the power distribution apparatus. The electrical component generates a large amount of heat during the operation of the power distribution apparatus, and as a result the electrical component is prone to thermal failure.

In this way, some embodiments of this application provide a power distribution apparatus. In the power distribution apparatus, the insulating heat conduction member may be connected to the electrical component with thermal insulation, and the insulating heat conduction member may be connected to an external heat exchange member with thermal insulation. Based on this, in one aspect, through the insulating performance of the insulating heat conduction member, the insulation between the electrical component and the heat exchange member by the insulating heat conduction member can be ensured, so that a short circuit among the electrical component, the insulating heat conduction member, and the heat exchange member can be basically avoided, thereby effectively reducing a risk of high-voltage short-circuit arcing among the electrical component, the insulating heat conduction member, and the heat exchange member. In another aspect, heat exchange and heat conduction between the electrical component and the heat exchange member through the insulating heat conduction member can be facilitated, especially, the conduction of heat generated by the electrical component to the heat exchange member through the insulating heat conduction member can be facilitated, thereby dissipating and conducting the heat generated by the electrical component outside the power distribution apparatus. In this way, the heat dissipation performance and the heat dissipation efficiency of the power distribution apparatus for the electrical component can be effectively ensured and enhanced, thereby effectively reducing a risk of thermal failure of the electrical component, and effectively ensuring and prolonging the service life of the electrical component and the power distribution apparatus.

The power distribution apparatus disclosed in the embodiments of this application may be used in batteries as a control unit that distributes battery energy, to perform high-voltage distribution for the batteries.

The battery disclosed in the embodiments of this application may be a modular structure, for example, a battery pack module, or a battery pack, that includes at least one battery cell to provide a higher voltage and a higher capacity. The battery cell may be a lithium-ion secondary battery, a lithium-ion primary battery, a lithium-sulfur battery, a sodium-lithium-ion battery, a sodium-ion battery, a magnesium-ion battery, or the like. The battery cell may be cylindrical, flat, cuboid, or in other shapes. The battery cell may use different encapsulating methods to form a cylindrical battery cell, a square battery cell, a soft package battery cell, or the like.

The battery disclosed in the embodiments of this application may be used in a power consuming device that uses a battery as a power supply or used in various energy storage systems that use a battery as an energy storage element. The power consuming device may be, but is not limited to, a vehicle, a mobile phone, a portable apparatus, a laptop computer, a ship, a spacecraft, an electronic toy, or an electric tool. The vehicle may be a fuel powered vehicle, a gas powered vehicle, or a new energy vehicle. The new energy vehicle may be a pure electric vehicle, a hybrid electric vehicle, or an extended range vehicle, etc. The spacecraft includes an airplane, a rocket, a space shuttle, a spaceship, and the like. The electric toys includes stationary or mobile electric toys, for example, game consoles, electric vehicle toys, electric ship toys, and electric aircraft toys. The electric tool includes a metal-cutting power tool, a grinding power tool, an assembly power tool and a railway power tool, for example, an electric drill, an electric grinder, an electric wrench, an electric screwdriver, an electric hammer, an electric impact drill, a concrete vibrator, and an electric planer.

To describe the technical solutions provided in this application, an example in which the power consuming device is a vehicle is used for detailed description below with reference to specific accompanying drawings and embodiments.

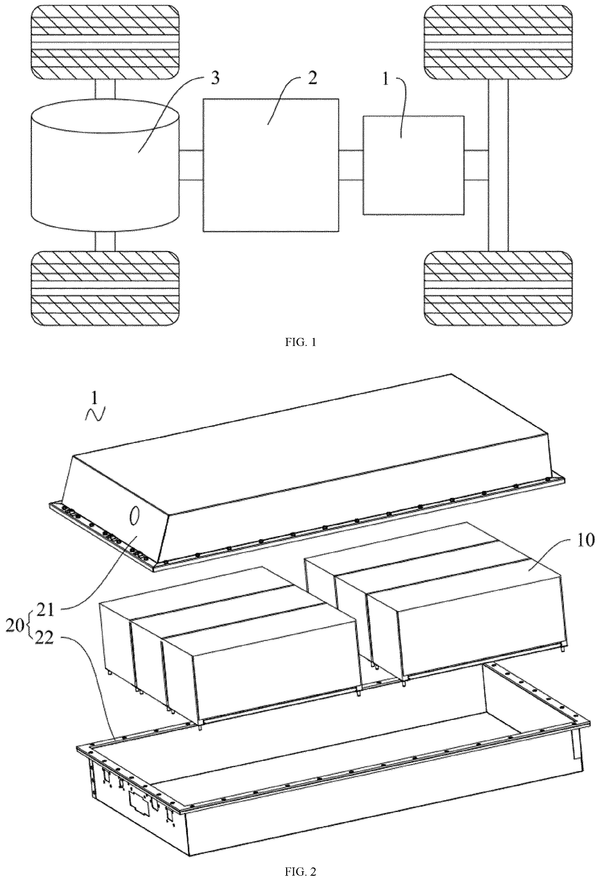

FIG. 1 is a schematic diagram of a structure of a vehicle according to some embodiments of this application. The vehicle may be a fuel powered vehicle, a gas powered vehicle, or a new energy vehicle. The new energy vehicle may be a pure electric vehicle, a hybrid electric vehicle, or an extended range vehicle, etc. The inner part of the vehicle is provided with a battery 1. The battery 1 may be disposed at the bottom, head, or tail of the vehicle. The battery 1 is configured to supply power to the vehicle. For example, the battery 1 may be used as a power supply for operating the vehicle. The vehicle may further include a controller 2 and a motor 3. The controller 2 is configured to control the battery 1 to supply power to the motor 3, for example, to meet working power requirements during starting, navigation, and traveling of the vehicle.

In some embodiments of this application, the battery 1 can not only serve as a power supply for operating the vehicle, but can also serve as a power supply for driving the vehicle, in place of or partially in place of fuel or natural gas, to provide driving power for the vehicle.

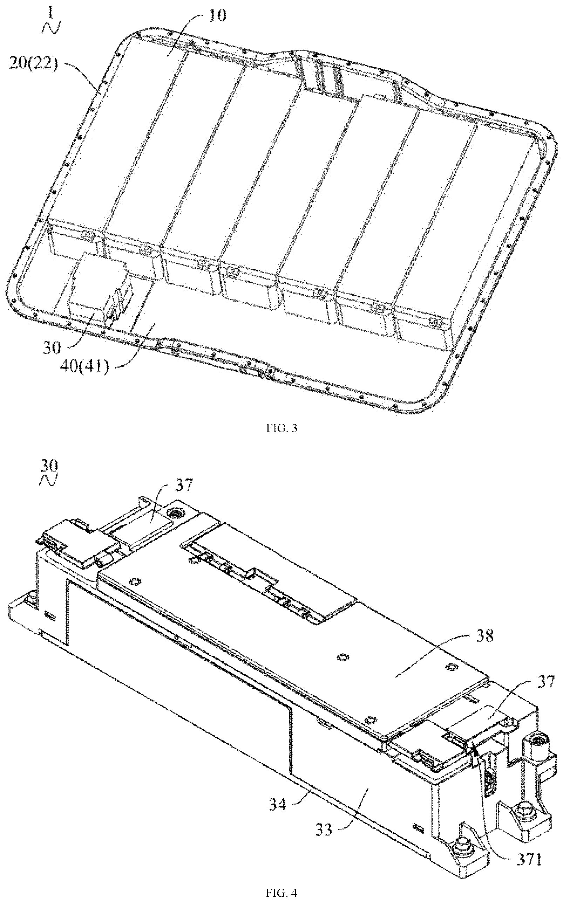

FIG. 2 is a schematic exploded view of a battery 1 according to some embodiments of this application. FIG. 3 is a partial schematic structural diagram of a battery 1 according to some embodiments of this application. The battery 1 includes a battery unit 10 and a housing 20. The battery unit 10 is accommodated in the housing 20. The housing 20 is configured to provide an accommodating space for the battery unit 10. The structure of the housing 20 may use a variety of flexible designs. In some embodiments, the housing 20 may include a first part 21 and a second part 22, the first part 21 and the second part 22 cover each other, and the first part 21 and the second part 22 jointly define the accommodating space for accommodating the battery units 10. The second part 22 may be a hollow structure with an opening at one end, the first part 21 may be a plate-like structure, and the first part 21 covers an opening side of the second part 22, so that the first part 21 and the second part 22 jointly define the accommodating space. Alternatively, the first part 21 and the second part 22 each may be a hollow structure with an opening on one side, and an opening side of the first part 21 covers an opening side of the second part 22. Certainly, the housing 20 formed by the first part 21 and the second part 22 may be in various shapes, such as a cylinder, and a cuboid.

In the battery 1, at least two battery units 10 may be provided, and the at least two battery units 10 can be connected in series, parallel, or series-parallel. A series-parallel connection means that both and series connection and a parallel connection exist among the at least two battery units 10.

For example, the battery unit 10 may be a battery cell. At least two battery cells may be directly connected in series, parallel, or series-parallel together, and then the whole formed by the at least two battery cells is accommodated in the housing 20. The battery cell may be a lithium-ion secondary battery, a lithium-sulfur battery, a sodium-lithium-ion battery, a sodium-ion battery, a magnesium-ion battery, or the like. The battery cell may be cylindrical, flat, cuboid, or in other shapes. The battery cell may use different encapsulating methods to form a cylindrical battery cell, a square battery cell, a soft package battery cell, or the like.

Alternatively, the battery unit 10 may be a battery module or a battery pack module. The at least two battery cells may be first connected in series, parallel, or series-parallel to form a modular structure, i.e., the battery module or the battery pack module. At least two battery modules or battery pack modules are then connected in series, parallel, or series-parallel to form a whole, and are accommodated in the housing 20.

In some embodiments, the battery 1 may further include a power distribution apparatus 30. The power distribution apparatus 30 is accommodated in the accommodating space of the housing 20. The power distribution apparatus 30 is connected to the battery unit 10, or the like. The power distribution apparatus 30 may be used as a control unit that distributes energy of the battery 1, to perform high-voltage distribution for the battery 1.

In some embodiments, the battery 1 may further include a thermal management element 41. The thermal management element 41 is accommodated in the accommodating space of the housing 20, and is configured to perform heat exchange with elements such as the battery unit 10 and the power distribution apparatus 30, to adjust the temperature of the battery 1. The thermal management element 41 may be a liquid cooling plate. In some embodiments, one thermal management element 41 may be provided, and is disposed on the same side as the elements such as battery unit 10 and the power distribution apparatus 30, thereby facilitating the heat exchange with the elements such as the battery unit 10 and the power distribution apparatus 30. Certainly, in some embodiments, at least two thermal management elements 41 may be alternatively provided, to facilitate the flexible design of the position and state of the thermal management elements 41, thereby facilitating respective heat exchange between the at least two thermal management elements 41 and the elements such as the battery unit 10 and the power distribution apparatus 30. The thermal management element 41 may be alternatively an air cooling system. An airflow generated by the air cooling system may pass through the elements such as the battery unit 10 and the power distribution apparatus 30, thereby the heat exchange with the elements such as the battery unit 10 and the power distribution apparatus 30. Certainly, the thermal management element 41 may be alternatively in another structural form.

Certainly, the battery 1 may further include other structures. For example, the battery 1 may further include a bus element (not shown in the figure) for achieving the electrical connection between the at least two battery units 10.

Certainly, in some embodiments, the battery 1 may not include the housing 20. Instead, the at least two battery units 10 are electrically connected, and form a whole through a necessary fixing structure to be assembled in the power consuming device.

Referring to FIG. 3, FIG. 4, FIG. 5, and FIG. 6, some embodiments of this application provide a power distribution apparatus 30. The power distribution apparatus 30 includes an electrical component 31 and an insulating heat conduction member 32. One side of the insulating heat conduction member 32 is connected to at least a part of the electrical component 31. The other side of the insulating heat conduction member 32 is configured to be connected to a heat exchange member 40. The insulating heat conduction member 32 is configured to transfer heat from the electrical component 31 to the heat exchange member 40.

It should be noted that the electrical component 31 may refer to any electrical element in the power distribution apparatus 30. The electrical component 31 may include a relay 312, a current sensor 313, a fuse, a protection device 314, a pre-charge resistor 315, and the like. The relay 312 may include a main positive relay 3121, a main negative relay 3122, a pre-charge relay 3123, and the like. The current sensor 313 may include a shunt 3131, a Hall current sensor 3132, and the like. In some embodiments, the protection device 314 may be used as a fuse.

It should further be noted that the heat exchange member 40 may refer to an external element that performs heat exchange with elements such as the electrical component 31. The heat exchange member 40 has good heat conduction performance, and can perform heat exchange with elements such as the electrical component 31 and the insulating heat conduction member 32 quickly and reliably, and quickly conduct heat outside. For example, the heat exchange member 40 may be the thermal management element 41, or may be the housing 20 of the battery 1, or may be a vehicle body of the vehicle, or the like.

It should further be noted that the insulating heat conduction member 32 is at least an element configured to transfer heat from the electrical component 31 to the heat exchange member 40. When the power distribution apparatus 30 is disposed on the heat exchange member 40, the insulating heat conduction member 32 is disposed between the electrical component 31 and the heat exchange member 40.

The insulating heat conduction member 32 includes a heat conduction material, has heat conduction performance, and can achieve heat conduction, i.e., achieve heat exchange and heat conduction. One side of the insulating heat conduction member 32 is thermally connected to at least a part of the electrical component 31. The other side of the insulating heat conduction member 32 is thermally connected to the heat exchange member 40. Based on this, the electrical component 31 can perform heat exchange with the heat exchange member 40 through the insulating heat conduction member 32 quickly and reliably, especially, the insulating heat conduction member 32 can quickly conduct heat generated by the electrical component 31 to the heat exchange member 40. In this way, the heat dissipation performance and the heat dissipation efficiency of the power distribution apparatus 30 for the electrical component 31 can be ensured and enhanced, the risk of thermal failure of the electrical component 31 can be reduced, and the service life of the electrical component 31 and the power distribution apparatus 30 can be ensured and prolonged.

The insulating heat conduction member 32 further includes an insulating material, has insulating performance, and can achieve insulation. Based on this, through the insulating performance of the insulating heat conduction member 32, the insulation between the electrical component 31 and the heat exchange member 40 by the insulating heat conduction member 32 can be ensured, so that a short circuit among the electrical component 31, the insulating heat conduction member 32, and the heat exchange member 40 can be avoided, thereby effectively reducing a risk of high-voltage short-circuit arcing among the electrical component 31, the insulating heat conduction member 32, and the heat exchange member 40.

The insulating heat conduction member 32 may be a single-layer structure or a multi-layer structure.

The shape of the insulating heat conduction member 32 may use a variety of designs, for example, a cuboid, or a cylinder.

Based on ensuring the heat conductivity and insulativity between the insulating heat conduction member 32 and the electrical component 31, a connection manner between the insulating heat conduction member 32 and the electrical component 31 may be flexibly designed, for example, may be abutting, bonding, or secure fastening with a bolt.

In summary, in the power distribution apparatus 30 provided in the embodiments of this application, the insulating heat conduction member 32 may be connected to the electrical component 31 with thermal insulation, and the insulating heat conduction member 32 may be connected to an external heat exchange member 40 with thermal insulation. Based on this, in one aspect, through the insulating performance of the insulating heat conduction member 32, the insulation between the electrical component 31 and the heat exchange member 40 by the insulating heat conduction member 32 can be ensured, so that a short circuit among the electrical component 31, the insulating heat conduction member 32, and the heat exchange member 40 can be basically avoided, thereby effectively reducing a risk of high-voltage short-circuit arcing among the electrical component 31, the insulating heat conduction member 32, and the heat exchange member 40. In another aspect, heat exchange and heat conduction between the electrical component 31 and the heat exchange member 40 through the insulating heat conduction member 32 can be facilitated, especially, the conduction of heat generated by the electrical component 31 to the heat exchange member 40 through the insulating heat conduction member 32 can be facilitated, thereby dissipating and conducting the heat generated by the electrical component 31 outside the power distribution apparatus 30. In this way, the heat dissipation performance and the heat dissipation efficiency of the power distribution apparatus 30 for the electrical component 31 can be effectively ensured and enhanced, thereby effectively reducing a risk of thermal failure of the electrical component 31, and effectively ensuring and prolonging the service life of the electrical component 31 and the power distribution apparatus 30.

Referring to FIG. 3, FIG. 4, and FIG. 5, in some embodiments of this application, the electrical component 31 includes a sheet conductive structure 311, the conductive structure 311 is provided with a heat conduction surface 3111, and the heat conduction surface 3111 is connected to the insulating heat conduction member 32.

It should be noted that the conductive structure 311 is an element of the electrical component 31 that is configured to implement an electrical connection. The conductive structure 311 may have a sheet form. The conductive structure 311 may include a busbar, a bus, a conductive sheet, and the like. The busbar may include a copper busbar, an aluminum busbar, and the like.

The conductive structure 311 is provided with the heat conduction surface 3111. The heat conduction surface 3111 may be thermally attached to the insulating heat conduction member 32. With such an arrangement, the conductive structure 311 of the electrical component 31 that generates a large amount of heat during operation can be directly thermally attached to the insulating heat conduction member 32 through the heat conduction surface 3111. Based on this, a heat conduction contact area between the conductive structure 311 and the insulating heat conduction member 32 can be ensured and increased, so that a large amount of heat generated by the conductive structure 311 can be reliably and effectively conducted to the heat exchange member 40 through the insulating heat conduction member 32. In this way, the heat dissipation performance and the heat dissipation efficiency of the power distribution apparatus 30 for the electrical component 31 can be effectively ensured and enhanced, thereby effectively reducing a risk of thermal failure of the electrical component 31, and effectively ensuring and prolonging the service life of the electrical component 31 and the power distribution apparatus 30.

In addition, based on the insulation characteristic of the insulating heat conduction member 32, the conductive structure 311 can be insulated from the insulating heat conduction member 32. With such an arrangement, a short circuit between the conductive structure 311 and the insulating heat conduction member 32 can be basically avoided, and a risk of high-voltage short circuit arcing between the conductive structure 311 and the insulating heat conduction member 32 can be reduced.

Through the use of the foregoing solution, the heat conduction surface 3111 of the conductive structure 311 of the electrical component 31 is connected to the insulating heat conduction member 32, so that in one aspect, based on the insulation characteristic of the insulating heat conduction member 32, the conductive structure 311 can be insulated from the insulating heat conduction member 32, thereby basically avoiding a short circuit between the conductive structure 311 and the insulating heat conduction member 32, and reducing a risk of high-voltage short circuit arcing between the conductive structure 311 and the insulating heat conduction member 32. In another aspect, the conductive structure 311 of the electrical component 31 that generates a large amount of heat during operation can be directly thermally attached to the insulating heat conduction member 32 through the heat conduction surface 3111. Based on this, a heat conduction contact area between the conductive structure 311 and the insulating heat conduction member 32 can be ensured and increased, so that a large amount of heat generated by the conductive structure 311 can be reliably and effectively conducted to the heat exchange member 40 through the insulating heat conduction member 32. In this way, the heat dissipation performance and the heat dissipation efficiency of the power distribution apparatus 30 for the electrical component 31 can be effectively ensured and enhanced, thereby effectively reducing a risk of thermal failure of the electrical component 31, and effectively ensuring and prolonging the service life of the electrical component 31 and the power distribution apparatus 30.

Certainly, in other embodiments, the electrical component 31 can be connected to the insulating heat conduction member 32 by a non-sheet conductive structure 311 with thermal insulation. Alternatively, the electrical component 31 can be connected to the insulating heat conduction member 32 by a portion outside the conductive structure 311 with thermal insulation.

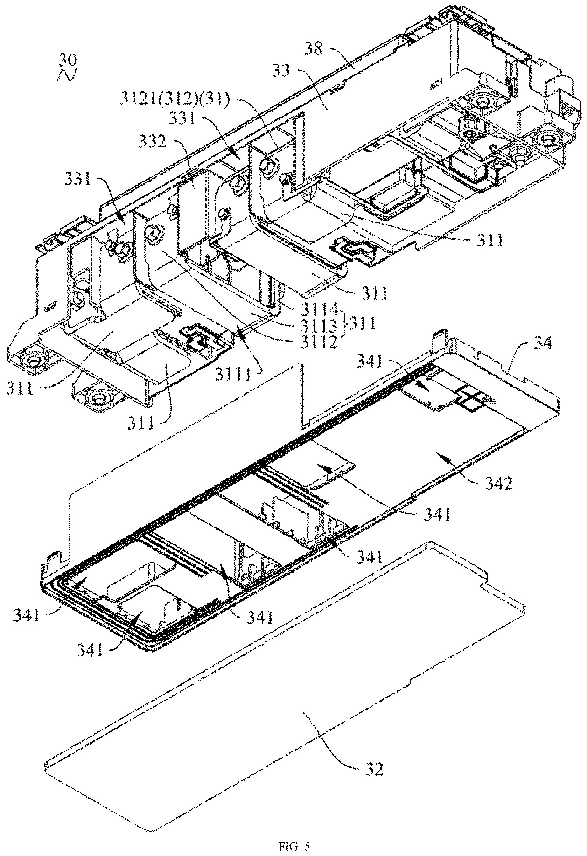

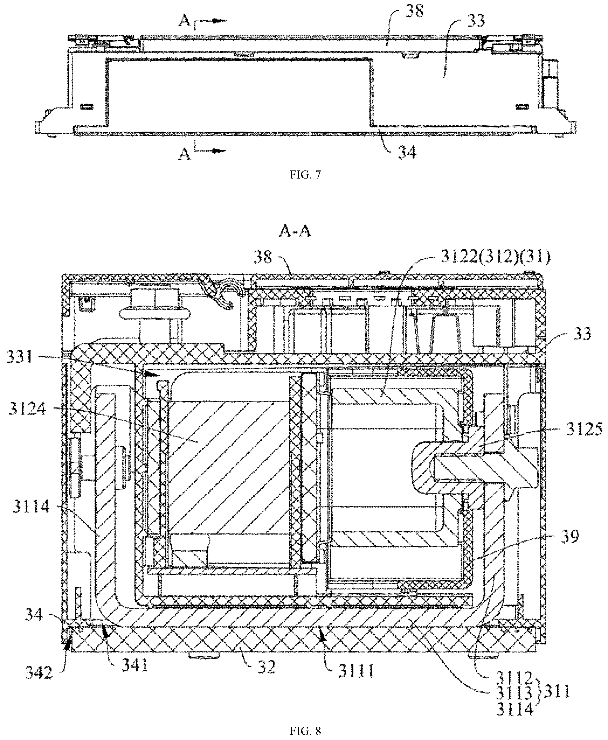

Referring to FIG. 5, FIG. 7, and FIG. 8, in some embodiments of this application, the power distribution apparatus 30 includes a case 33. The case 33 is configured to mount the electrical component 31. The conductive structure 311 includes a first conductive portion 3112, a second conductive portion 3113, and a third conductive portion 3114. The second conductive portion 3113 is disposed on a side of the case 33 that faces the insulating heat conduction member 32. The heat conduction surface 3111 is provided on a side of the second conductive portion 3113 that faces the insulating heat conduction member 32. The first conductive portion 3112 and the third conductive portion 3114 are respectively connected to different sides of the second conductive portion 3113, and are both bent toward a side close to the case 33. The first conductive portion 3112 is connected to a corresponding electrical component 31. The third conductive portion 3114 is configured to be connected to an electrical element.

It should be noted that the case 33 is an element configured to mount the electrical component 31. Both the structure and shape of the case 33 may use a variety of designs. When a plurality of electrical components 31 are provided, the layout of the plurality of electrical components 31 in the case 33 may be flexibly designed as required.

The electrical component 31 may be mounted through the case 33, so that the electrical component 31 is protected through the case 33, and a mounting position and a mounting state of the electrical component 31 with respect to the case 33 are stable and secure. In this way, the service life of the electrical component 31 can be ensured and prolonged. The electrical component 31 and the insulating heat conduction member 32 can be precisely and stably aligned, to precisely and reliably establish a thermal insulation connection relationship with the insulating heat conduction member 32. A mutual stable position and state between the electrical component 31 and another electrical element can be facilitated, to stably and reliably establish an electrical connection relationship with another electrical element.

The electrical element refers to an element that establishes an electrical connection to the electrical component 31. The electrical element may be another electrical component 31, or may be a circuit (which is not limited to a circuit board), an external bus, or the like. Electrical elements electrically connected to different electrical components 31 may be the same or may be different.

It should further be noted that the conductive structure 311 is an element configured to electrically connect the corresponding electrical component 31 to the corresponding electrical element. The corresponding electrical component 31 is an electrical component 31 that includes the conductive structure 311 and is electrically connected to the conductive structure 311. The corresponding electrical element is another element electrically that is other than the corresponding electrical component 31 and is connected to the conductive structure 311. In other words, the corresponding electrical component 31 and the corresponding electrical element are two elements connected to the conductive structure 311.

The conductive structure 311 is a sheet structure. The conductive structure 311 includes the first conductive portion 3112, the second conductive portion 3113, and the third conductive portion 3114 that are sequentially connected. The first conductive portion 3112 is connected to the corresponding electrical component 31, and is disposed extending toward a side close to the insulating heat conduction member 32. The third conductive portion 3114 is connected to the corresponding electrical element, and is disposed extending toward the side close to the insulating heat conduction member 32. The second conductive portion 3113 is bent and connected to an end of the first conductive portion 3112 that is close to the insulating heat conduction member 32 and an end of the third conductive portion 3114 that is close to the insulating heat conduction member 32. That is, the second conductive portion 3113 is connected to the end of the third conductive portion 3114 that is close to the insulating heat conduction member 32 from the end of the first conductive portion 3112 that is close to the insulating heat conduction member 32. The second conductive portion 3113 and the first conductive portion 3112 are disposed at an angle. The second conductive portion 3113 and the third conductive portion 3114 are disposed at an angle.

Based on the layout of the corresponding electrical component 31 and the corresponding electrical element and the shape of the second conductive portion 3113, the first conductive portion 3112 and the third conductive portion 3114 may be respectively connected to different sides of the second conductive portion 3113. That is, the first conductive portion 3112 and the third conductive portion 3114 may be respectively connected to adjacent sides of the second conductive portion 3113, or may be respectively connected to opposite sides of the second conductive portion 3113, or the like. That is, the overall form of the conductive structure 311 may be flexibly designed as required.

Through the first conductive portion 3112, the second conductive portion 3113, and the third conductive portion 3114 that are sequentially bent and connected, the conductive structure 311 can conveniently and reliably electrically connect the corresponding electrical component 31 to the corresponding electrical element.

It should further be noted that the second conductive portion 3113 is disposed on the side of the case 33 that faces the insulating heat conduction member 32. That is, the second conductive portion 3113 is disposed on the side of the case 33 that faces the insulating heat conduction member 32 with a posture of "basically parallel to a side surface of the case 33 that faces the insulating heat conduction member 32". In this case, on a side of the second conductive portion 3113 that faces the insulating heat conduction member 32, the second conductive portion 3113 may form the foregoing heat conduction surface 3111, and is configured to be thermally attached to the insulating heat conduction member 32. Based on this, the conductive structure 311 may be directly connected to the insulating heat conduction member 32 with thermal insulation through the heat conduction surface 3111 of the second conductive portion 3113, so that the obstruction of a heat conduction path between the conductive structure 311 and the insulating heat conduction member 32 by the case 33 can be reduced, and the heat conduction contact area between the conductive structure 311 and the insulating heat conduction member 32 can be ensured and increased.

Through the use of the foregoing solution, the electrical component 31 may be mounted through the case 33, so that the electrical component 31 is protected, and a mounting position and a mounting state of the electrical component 31 with respect to the case 33 are stable and secure. Based on this, the service life of the electrical component 31 can be ensured and prolonged. In addition, the electrical component 31 and the insulating heat conduction member 32 can be precisely and stably aligned, so that the electrical component 31 can precisely and reliably establish a thermal insulation connection relationship with the insulating heat conduction member 32. In addition, a mutual stable position and state between the electrical component 31 and another electrical element can be facilitated, so that the electrical component 31 can stably and reliably establish an electrical connection relationship with another electrical element.

Through the use of the foregoing solution, through the conductive structure 311, especially through the first conductive portion 3112, the second conductive portion 3113, and the third conductive portion 3114 that are sequentially bent and connected, the corresponding electrical component 31 can be conveniently and reliably electrically connected to the corresponding electrical element. Based on this, the second conductive portion 3113 may be further disposed on the side of the case 33 that faces the insulating heat conduction member 32, and the heat conduction surface 3111 is disposed on the side of the second conductive portion 3113 that faces the insulating heat conduction member 32, so that the conductive structure 311 can be directly connected to the insulating heat conduction member 32 with thermal insulation through the heat conduction surface 3111 of the second conductive portion 3113. Based on this, the obstruction of a heat conduction path between the conductive structure 311 and the insulating heat conduction member 32 by the case 33 can be reduced, and the heat conduction contact area between the conductive structure 311 and the insulating heat conduction member 32 can be ensured and increased. In this way, the heat conduction between the conductive structure 311 and the insulating heat conduction member 32 can be ensured and enhanced, a large amount of heat generated by the conductive structure 311 can be quickly conducted out reliably and effectively through the insulating heat conduction member 32, and the heat dissipation performance and the heat dissipation efficiency of the power distribution apparatus 30 for the electrical component 31 can be ensured and enhanced.

Referring to FIG. 5, FIG. 8, and FIG. 9, in some embodiments of this application, the case 33 is provided with at least one accommodating cavity 331. At least one electrical component 31 is a relay 312. The relay 312 is fixedly mounted in the accommodating cavity 331. The relay 312 includes a switch unit 3124. At least a portion of an outer wall of the switch unit 3124 is exposed from the accommodating cavity 331. A wall of the accommodating cavity 331 is connected to the relay 312 to fix the relay 312 in the accommodating cavity 331. The conductive structure 311 of the relay 312 is disposed outside the accommodating cavity 331, and the second conductive portion 3113 of the relay 312 is disposed on an outer side of the accommodating cavity 331 that is close to the insulating heat conduction member 32.

It should be noted that the case 33 is provided with at least one accommodating cavity 331, and the accommodating cavity 331 may be configured to fixed and mount the relay 312. The accommodating cavity 331 is provided with an opening. The opening of the accommodating cavity 331 may allow the relay 312 to be inserted into and removed from the accommodating cavity 331. The opening of the accommodating cavity 331 may be provided on any side of the case 33. When at least two accommodating cavities 331 are provided, openings of the at least two accommodating cavities 331 may be provided on the same side of the case 33, or may be separately provided on different sides of the case 33.

It should further be noted that the at least one electrical component 31 is a relay 312. The relay 312 is an electrical control component, and is an electrical component 31 that enables a controlled quantity to undergo a predetermined step change in an electric output circuit when a change in an input quantity (an excitation quantity) meets a specified requirement. The relay 312 may include the main positive relay 3121, the main negative relay 3122, and the like.

The relay 312 includes a contact 3125 and a switch unit 3124. The contact 3125 is configured to be connected to a high-voltage circuit. The switch unit 3124 is configured to control the contact 3125 to be closed or opened. On or off of the high-voltage circuit may be controlled through the closing or opening of the contact 3125. In some embodiments, the switch unit 3124 may be energized to generate an electromagnetic field to cause the contact 3125 to be closed or opened. For example, the switch unit 3124 may include an iron core 31241 and a coil 31242 wound around the iron core 31241. The coil 31242 may generate an electromagnetic field when energized, to cause the contact 3125 to be closed or opened. Certainly, in other embodiments, the switch unit 3124 may use another structural form, or another principle may be used, to control the contact 3125 to be closed or opened.

It should further be noted that the relay 312 may be fixedly mounted in the accommodating cavity 331. An arrangement quantity of the relays 312 may be greater than or equal to an arrangement quantity of the accommodating cavities 331, so that at least some relays 312 may be fixedly mounted in the accommodating cavities 331 in a one-to-one correspondence.

The relay 312 fixedly mounted in the accommodating cavity 331 may enable at least a portion of the outer wall of the switch unit 3124 of the relay 312 to be exposed from the accommodating cavity 331. The outer wall of the switch unit 3124 includes exposed outer surface portions of elements of the switch unit 3124. For example, the switch unit 3124 includes the iron core 31241 and the coil 31242 wound around the iron core 31241. If an outer peripheral surface of the iron core 31241 is fully wound and covered by the coil 31242, the outer wall of the switch unit 3124 mainly includes an outer peripheral surface of an outermost ring of the coil 31242. If the outer peripheral surface of the iron core 31241 is partially wound and covered by the coil 31242, the outer wall of the switch unit 3124 includes an outer peripheral surface of an outermost ring of the coil 31242 and an outer peripheral surface of a portion of the iron core 31241 that is not covered by the coil 31242. For another example, the switch unit 3124 includes the iron core 31241, the coil 31242 wound around the iron core 31241, and a bracket 31243 configured to support and fix the iron core 31241. In this case, the outer wall of the switch unit 3124 may include an outer surface of the bracket 31243, an outer peripheral surface of a portion of the outermost ring of the coil 31242 that is not covered by the bracket 31243, and an outer peripheral surface of a portion of the iron core 31241 that is not covered by the bracket 31243 and the coil 31242.

Based on this, the relay 312 fixedly mounted in the accommodating cavity 331 can use the wall of the accommodating cavity 331 in place of a casing structure of the relay 312 to protect the relay 312. In this way, the casing structure of the relay 312 can be omitted, i.e., the relay 312 fixedly mounted in the accommodating cavity 331 is an unhoused relay 312.

Based on this, the wall of the accommodating cavity 331 may be connected to the relay 312 located in the accommodating cavity 331 to fix the relay 312 in the accommodating cavity 331 and limit the relay 312 from being disengaged from the accommodating cavity 331, especially limit the relay 312 from being disengaged from the accommodating cavity 331 due to vibration during operation. The wall of the accommodating cavity 331 may be connected to the relay 312 in a detachable connection manner or a fixed connection manner, to fix the relay 312 in the accommodating cavity 331. The detachable connection manner may be, but is not limited to, a snap-fit clip connection manner, or a screw fastening manner. The fixed connection manner may be, but is not limited to, a bonding manner.

Through the use of the foregoing solution, the relay 312 may be accommodated in the accommodating cavity 331 of the case 33, and the wall of the accommodating cavity 331 is connected to the relay 312, thereby fixing the relay 312 in the accommodating cavity 331. Based on this, for the relay 312 fixedly mounted in the accommodating cavity 331, at least a portion of the outer wall of the switch unit 3124 of the relay 312 may be exposed from the accommodating cavity 331, so that the wall of the accommodating cavity 331 is used in place of a casing structure of the relay 312 to protect the relay 312. Based on this, based on ensuring that the case 33 can accommodate, limit, fix, and protect the relay 312, the casing structure of the relay 312 can be effectively omitted. In this way, the overall layout of the case 33 and the relay 312 is compact, the power distribution apparatus 30 featuring integration, miniaturization, lightweight, and simplicity can be formed, the design margins, space waste, and an occupied space of the power distribution apparatus 30 can be effectively reduced, the mass of the power distribution apparatus 30 can be effectively reduced, and the production costs of the power distribution apparatus 30 can be reduced.

It should further be noted that the conductive structure 311 of the relay 312 is a conductive structure 311 configured to electrically connect the relay 312 to another electrical element, and is disposed outside the accommodating cavity 331 without additionally occupying an internal space of the accommodating cavity 331. Particularly, the second conductive portion 3113 of the conductive structure 311 of the relay 312 is disposed on the outer side of the accommodating cavity 331 that is close to the insulating heat conduction member 32.

Through the use of the foregoing solution, the conductive structure 311 of the relay 312 may be disposed outside the accommodating cavity 331, so that the conductive structure 311 can electrically connect the relay 312 to another electrical element without additionally occupying an internal space of the accommodating cavity 331. Based on this, the design margins and space waste between the case 33 and the relay 312 can be reduced, the assembly and cooperation of the case 33, the relay 312, the conductive structure 311 of the relay 312, the electrical element connected to the conductive structure 311 of the relay 312, and the like can be facilitated, and the conductive structure 311 can electrically connect the relay 312 to another electrical element conveniently and reliably. Based on this, the second conductive portion 3113 of the relay 312 may further be disposed on the outer side of the accommodating cavity 331 that is close to the insulating heat conduction member 32, so that the second conductive portion 3113 of the relay 312 may be exposed from the outer side of the accommodating cavity 331 that is close to the insulating heat conduction member 32, making it convenient for the conductive structure 311 of the relay 312 to be directly connected to the insulating heat conduction member 32 with thermal insulation through the second conductive portion 3113. In this way, the obstruction of the heat conduction path between the conductive structure 311 of the relay 312 and the insulating heat conduction member 32 by the wall of the accommodating cavity 331 can be reduced, the heat conduction contact area between the conductive structure 311 of the relay 312 and the insulating heat conduction member 32 can be increased, the heat conduction between the relay 312 and the insulating heat conduction member 32 can be enhanced, heat generated by the relay 312 and the conductive structure 311 of the relay 312 can be quickly conducted out reliably and effectively through the insulating heat conduction member 32, the heat dissipation performance and the heat dissipation efficiency of the power distribution apparatus 30 for the relay 312 can be enhanced, and a risk of thermal failure of the relay 312 can be reduced.

Referring to FIG. 5, FIG. 6, and FIG. 9, in some embodiments of this application, at least two accommodating cavities 331 are provided, and the at least two accommodating cavities 331 are disposed adjacently. At least one insulating structure 332 is provided in the case 33. The insulating structure 332 is disposed between the two adjacently disposed accommodating cavities 331, and is configured to isolate the contacts 3125 of two corresponding relays 312.

It should be noted that at least two accommodating cavities 331 are provided. One relay 312 is fixedly mounted in each accommodating cavity 331. Theoretically, the at least two accommodating cavities 331 may be flexibly arranged. Due to the compact layout, in some cases, at least two accommodating cavities 331 are arranged adjacently, and the unhoused relays 312 in the two adjacently disposed accommodating cavities 331 are close to each other, particularly, the contacts 3125 of the two adjacently disposed relays 312 are close to each other.

Based on this, the insulating structure 332 may be disposed between the two adjacently arranged accommodating cavities 331 in the case 33. At least one insulating structure 332 may be disposed between each group of two adjacently disposed accommodating cavities 331. The insulating structure 332 further includes an insulating material, has insulating performance, and can achieve insulation. The insulating structure 332 may insulate the accommodating cavities 331 on two sides of the insulating structure 332, particularly, may insulate two relays 312 correspondingly mounted in two accommodating cavities 331, particularly, may insulate the contacts 3125 of two corresponding relays 312, thereby enhancing the insulativity between the contacts 3125 of the relays 312 on two opposite sides of the insulating structure 332.

The structure of the insulating structure 332 may use a variety of designs. For example, the insulating structure 332 may be a frame structure with an end-to-end connection.

The insulating structure 332 is an integrally formed element of the case 33, or may be separately formed elements.

Through the use of the foregoing solution, the insulating structure 332 may be disposed between the two adjacently disposed accommodating cavities 331 in the case 33, so that the two adjacently disposed accommodating cavities 331 are insulated by the insulating structure 332, thereby insulating two relays 312 correspondingly mounted in two accommodating cavities 331 by the insulating structure 332, and particularly, insulating the contacts 3125 of the two corresponding relays 312. In this way, the insulativity between the contacts 3125 of the two adjacently disposed unhoused relays 312 can be effectively enhanced, so that a short circuit risk can be reduced, thereby enhancing the use reliability and the use safety of the power distribution apparatus 30.

Referring to FIG. 3, FIG. 5, and FIG. 6, in some embodiments of this application, the power distribution apparatus 30 includes a base 34, configured to be disposed on the heat exchange member 40. The insulating heat conduction member 32 is mounted on the base 34. A surface of the insulating heat conduction member 32 that faces away from the electrical component 31 is exposed from the base 34 and is connected to the heat exchange member 40.

It should be noted that when the power distribution apparatus 30 is disposed on the heat exchange member 40, the power distribution apparatus 30 is mainly disposed on the heat exchange member 40 through the base 34. The base 34 is at least an element configured to mount and fix the insulating heat conduction member 32.

The electrical component 31 is located on a side of the base 34 that faces away from the heat exchange member 40. In some embodiments, the electrical component 31 may be mounted on the case 33 and fixed through the connection between the case 33 and the base 34, and relative to the base 34, a mounting position and a mounting state are basically stable.

The insulating heat conduction member 32 is mounted on the base 34. A mounting manner between the insulating heat conduction member 32 and the base 34 may be flexibly designed. A side of the insulating heat conduction member 32 that faces the electrical component 31 is connected to the electrical component 31 with thermal insulation. The surface of the insulating heat conduction member 32 that faces away from the electrical component 31 is exposed from a side surface of the base 34 that faces the heat exchange member 40, and is thermally connected to the heat exchange member 40.

Through the use of the foregoing solution, the insulating heat conduction member 32 may be mounted and fixed through the base 34, so that a mounting position and a mounting state of the insulating heat conduction member 32 with respect to the base 34 are stable and secure, the insulating heat conduction member 32 and the electrical component 31 can be precisely and stably aligned, a and the insulating heat conduction member 32 can precisely and reliably establish a thermal insulation connection relationship with the electrical component 31. Based on this, a side of the insulating heat conduction member 32 that faces the electrical component 31 is connected to the electrical component 31 with thermal insulation, and a surface of the insulating heat conduction member 32 that faces away from the electrical component 31 is exposed from the base 34, and is thermally connected to heat exchange member 40. Therefore, the insulating heat conduction member 32 can be directly connected with thermal insulation between the electrical component 31 and the heat exchange member 40, the obstruction of a heat conduction path of the insulating heat conduction member 32 by the base 34 can be reduced, and the heat conduction of the insulating heat conduction member 32 between the electrical component 31 and heat exchange member 40 can be ensured and enhanced.

Certainly, in other embodiments, the power distribution apparatus 30 may not include the base 34. Instead, the insulating heat conduction member 32 is mounted and fixed on another element of the power distribution apparatus 30.

Referring to FIG. 3, FIG. 5, and FIG. 6, in some embodiments of this application, the insulating heat conduction member 32 is embedded in the base 34.

It should be noted that the insulating heat conduction member 32 is partially or fully embedded in the base 34. A side of the insulating heat conduction member 32 that faces the electrical component 31 is connected to the electrical component 31 with thermal insulation. The surface of the insulating heat conduction member 32 that faces away from the electrical component 31 is exposed from a side surface of the base 34 that faces the heat exchange member 40, and is thermally connected to the heat exchange member 40.

Through the use of the foregoing solution, based on the foregoing embodiment, the insulating heat conduction member 32 may be at least partially embedded in the base 34. Based on this, in one aspect, the insulating heat conduction member 32 can at least partially share a space with the base 34, so that an occupied space of the insulating heat conduction member 32 and the base 34 can be reduced. In another aspect, the insulating heat conduction member 32 may be directly connected between the electrical component 31 and the heat exchange member 40 with thermal insulation through the base 34, so that the obstruction of a heat conduction path of the insulating heat conduction member 32 by the base 34 can be reduced, and the heat conduction of the insulating heat conduction member 32 between the electrical component 31 and the heat exchange member 40 can be ensured and enhanced.

Referring to FIG. 5, FIG. 6, and FIG. 8, in some embodiments of this application, a first limiting structure 341 is disposed on a side of the base 34 that faces the electrical component 31, and is configured to limit and mount a portion of the electrical component 31 that is connected to the insulating heat conduction member 32.

It should be noted that the first limiting structure 341 is disposed on a side surface of the base 34 that faces the electrical component 31. The structure of the first limiting structure 341 may use a variety of designs. For example, the first limiting structure 341 may be a hole structure, or a groove structure, a frame structure, or the like.

A portion (for example, the second conductive portion 3113 discussed above) of the electrical component 31 that is configured to be thermally connected to the insulating heat conduction member 32 may be limited and mounted in the first limiting structure 341, and is connected to the surface of the insulating heat conduction member 32 that corresponds to the first limiting structure 341 with thermal insulation. In a case that the portion of the electrical component 31 that is configured to be thermally connected to the insulating heat conduction member 32 can be limited in the first limiting structure 341, the shape of the portion of the electrical component 31 and the shape of the first limiting structure 341 may be configured to be the same or may be configured to be different. The fit between the portion of the electrical component 31 and the first limiting structure 341 may be a clearance fit, a transition fit, or an interference fit.

Through the use of the foregoing solution, the first limiting structure 341 may be disposed on the base 34, so that a part of the electrical component 31 that is configured to be thermally connected to the insulating heat conduction member 32 is limited and mounted in the first limiting structure 341, and is connected to a surface at a position of the insulating heat conduction member 32 that corresponds to the first limiting structure 341 with thermal insulation. Based on this, the part of the electrical component 31 that is configured to be thermally connected to the insulating heat conduction member 32 may be limited and positioned through the first limiting structure 341 of the base 34, so that quick and precise alignment and cooperation of the electrical component 31 and the base 34 can be facilitated, the electrical component 31 can be precisely aligned with the insulating heat conduction member 32 mounted in the base 34, relative positions and relative states of the electrical component 31 and the insulating heat conduction member 32 can be stabilized, the electrical component 31 and the insulating heat conduction member 32 can be precisely and reliably connected with thermal insulation, and the heat conduction between the electrical component 31 and the insulating heat conduction member 32 can be ensured.

Certainly, in other embodiments, the first limiting structure 341 may be not disposed on the base 34. A surface of the insulating heat conduction member 32 that faces the electrical component 31 may be exposed from a corresponding side surface of the base 34, and is thermally connected to at least a part of the electrical component 31.

Referring to FIG. 5, FIG. 6, and FIG. 8, in some embodiments of this application, the first limiting structure 341 is a hole structure, and the first limiting structure 341 is in communication with a surface of the insulating heat conduction member 32.

It should be noted that in a case that the surface of the insulating heat conduction member 32 that faces the electrical component 31 is embedded in the base 34, the first limiting structure 341 may be designed as a hole structure. The first limiting structure 341 of the hole structure is in communication with a surface of the insulating heat conduction member 32. Particularly, the first limiting structure 341 may extend in a hole depth direction of the first limiting structure 341 and is in communication with a surface of the insulating heat conduction member 32 that is close to the electrical component 31. The first limiting structure 341 may be, but is not limited to, a rectangular hole, or a circular hole.

In this case, the portion of the electrical component 31 may be embedded and limited in the first limiting structure 341, and is thermally connected to the surface at the position of the insulating heat conduction member 32 that corresponds to the first limiting structure 341.

Through the use of the foregoing solution, in a case that a surface of the insulating heat conduction member 32 that faces the electrical component 31 is embedded in the base 34, the first limiting structure 341 of the hole structure is provided in the base 34, and the first limiting structure 341 is in communication with the surface of the insulating heat conduction member 32, so that the part of the electrical component 31 that is configured to be thermally connected to the insulating heat conduction member 32 can be inserted and limited in the first limiting structure 341, and is connected to the surface of the insulating heat conduction member 32 that corresponds to the first limiting structure 341 with thermal insulation. Based on this, the part of the electrical component 31 that is configured to be thermally connected to the insulating heat conduction member 32 may be limited and positioned by the first limiting structure 341, so that the electrical component 31 can be precisely aligned with the insulating heat conduction member 32, and is connected to the insulating heat conduction member 32 with thermal insulation tightly and reliably. Based on this, it can further be ensured that a part of the electrical component 31 can deeply enter the base 34, and can be directly connected to the insulating heat conduction member 32 with thermal insulation through the base 34, so that the obstruction of a heat conduction path between the electrical component 31 and the insulating heat conduction member 32 by the base 34 can be reduced, and the heat conduction between the insulating heat conduction member 32 and the electrical component 31 can be enhanced. In addition, a combined occupied space of the electrical component 31, the base 34, and the insulating heat conduction member 32 can be reduced.

Referring to FIG. 5, FIG. 6, and FIG. 8, in some embodiments of this application, a second limiting structure 342 is disposed on a side of the base 34 that faces away from the electrical component 31, and is configured to limit and mount the insulating heat conduction member 32.

It should be noted that the second limiting structure 342 is disposed on the side surface (i.e., the side surface of the base 34 that faces the heat exchange member 40) of the base 34 that faces the electrical component 31. The structure of the second limiting structure 342 may use a variety of designs. For example, the second limiting structure 342 may be a groove structure, or a hole structure, a frame structure, or the like.

The insulating heat conduction member 32 is limited and mounted on the second limiting structure 342. In a case that the insulating heat conduction member 32 is limited and mounted in the second limiting structure 342, the shape of the second limiting structure 342 and the shape of the insulating heat conduction member 32 may be configured to be the same or may be configured to be different. The fit between the insulating heat conduction member 32 and the second limiting structure 342 may be a clearance fit, a transition fit, or an interference fit.

Through the use of the foregoing solution, the second limiting structure 342 may be disposed on the side of the base 34 that faces away from the electrical component 31, so that the insulating heat conduction member 32 is limited and mounted in the second limiting structure 342. Based on this, the insulating heat conduction member 32 may be limited and accommodated through the second limiting structure 342 of the base 34, so that quick and precise assembly of the insulating heat conduction member 32 and the base 34 can be facilitated, the insulating heat conduction member 32 can be precisely aligned with the electrical component 31 to be thermally connected to the insulating heat conduction member 32, and the insulating heat conduction member 32 can precisely, stably, and reliably achieve heat conduction.

Referring to FIG. 5, FIG. 6, and FIG. 8, in some embodiments of this application, the second limiting structure 342 is a groove structure.

It should be noted that the second limiting structure 342 is disposed on the side surface of the base 34 that faces the electrical component 31. The second limiting structure 342 is a groove structure. The second limiting structure 342 may be, but is not limited to, a rectangular groove, or a circular groove. Based on this, the insulating heat conduction member 32 may be embedded in the second limiting structure 342.

Through the use of the foregoing solution, the second limiting structure 342 of the groove structure may be disposed in the base 34, so that the insulating heat conduction member 32 is embedded in the second limiting structure 342. Based on this, the insulating heat conduction member 32 may be limited and positioned by the second limiting structure 342, so that the insulating heat conduction member 32 can be precisely aligned with the base 34 and the electrical components 31, and the insulating heat conduction member 32 is connected to the electrical components 31 with thermal insulation tightly and reliably. Based on this, it can further be ensured that at least a part of the insulating heat conduction member 32 can deeply enter and be embedded in the base 34, and can be directly connected to the electrical component 31 with thermal insulation through the base 34, so that the obstruction of a heat conduction path between the electrical component 31 and the insulating heat conduction member 32 by the base 34 can be reduced, and the heat conduction between the insulating heat conduction member 32 and the electrical component 31 can be enhanced. In addition, a combined occupied space of the electrical component 31, the base 34, and the insulating heat conduction member 32 can be reduced.

Referring to FIG. 5, FIG. 6, and FIG. 8, in some embodiments of this application, the second limiting structure 342 and the insulating heat conduction member 32 are disposed in a one-to-one correspondence.

It should be noted that an arrangement quantity of the second limiting structures 342 corresponds to an arrangement quantity of the corresponding insulating heat conduction members 32, so that the insulating heat conduction members 32 may be embedded in the second limiting structures 342 in a one-to-one correspondence.

Through the use of the foregoing solution, the second limiting structure 342 may be embedded in the insulating heat conduction member 32 in a one-to-one correspondence, so that the limitation and positioning of the second limiting structure 342 for the insulating heat conduction member 32 can be ensured and enhanced, thereby ensuring the mounting convenience, mounting reliability, and mounting precision of the insulating heat conduction member 32, facilitating the precise and reliable connection between the insulating heat conduction member 32 and the corresponding electrical component 31 with thermal insulation, and facilitating the reliable heat dissipation of the insulating heat conduction member 32.

Certainly, in other embodiments, at least two insulating heat conduction members 32 may be embedded in one second limiting structure 342.

Referring to FIG. 5, FIG. 6, and FIG. 8, in some embodiments of this application, a side surface of the insulating heat conduction member 32 that faces away from the electrical component 31 protrudes from a groove opening of the second limiting structure 342.

It should be noted that the side surface of the insulating heat conduction member 32 that faces away from the electrical component 31 protruding from a groove opening of the second limiting structure 342 means that when the insulating heat conduction member 32 is embedded in the second limiting structure 342, the side surface of the insulating heat conduction member 32 that faces away from the electrical component 31 protrudes from a groove opening of the second limiting structure 342. With such an arrangement, the side surface of the insulating heat conduction member 32 that faces away from the electrical component 31 can protrude from the second limiting structure 342, and is directly thermally connected to the heat exchange member 40 (as shown in FIG. 3).

Through the use of the foregoing solution, in a case that the insulating heat conduction member 32 is embedded in the second limiting structure 342, the side surface of the insulating heat conduction member 32 that faces away from the electrical component 31 may protrude from the groove opening of the second limiting structure 342, so that the side surface of the insulating heat conduction member 32 that faces away from the electrical component 31 can be exposed from the second limiting structure 342. Based on this, the side surface of the insulating heat conduction member 32 that faces away from the electrical component 31 may be directly thermally connected to the heat exchange member 40, so that the obstruction of a heat conduction path between the insulating heat conduction member 32 and the heat exchange member 40 by the base 34 can be reduced, and the heat conduction between the insulating heat conduction member 32 and the heat exchange member 40 can be ensured and enhanced. In addition, because the side surface of the insulating heat conduction member 32 that faces away from the electrical component 31 protrudes from the groove opening of the second limiting structure 342, a dimension of the insulating heat conduction member 32 in a groove depth direction of the second limiting structure 342 is greater than a groove depth of the second limiting structure 342. In this way, even if the dimension of the insulating heat conduction member 32 in the groove depth direction of the second limiting structure 342 or the groove depth of the second limiting structure 342 has a processing error, when the insulating heat conduction member 32 is embedded in the second limiting structure 342, it can be basically ensured that the side surface of the insulating heat conduction member 32 that faces away from the electrical component 31 can be exposed from the second limiting structure 342, and is directly thermally connected to the heat exchange member 40. Therefore, based on the arrangement in this embodiment, particular processing errors can be accommodated and tolerated, and the requirement of cooperation precision between the insulating heat conduction member 32 and the second limiting structure 342 in the groove depth direction of the second limiting structure 342 can be lowered, thereby facilitating the processing and assembly of the insulating heat conduction member 32 and the base 34.

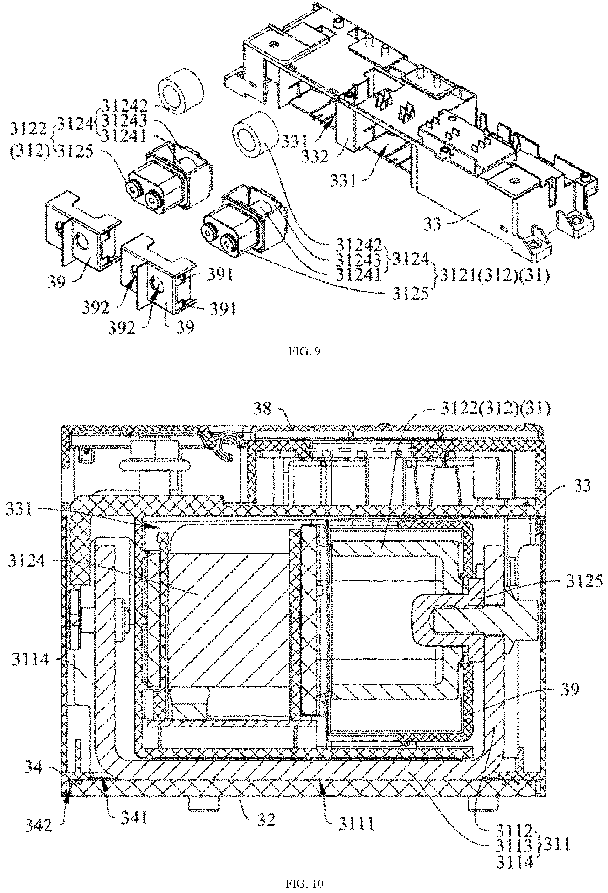

Referring to FIG. 3 and FIG. 10, in some embodiments of this application, a side surface of the insulating heat conduction member 32 that faces away from the electrical component 31 is flush with a groove opening of the second limiting structure 342.

It should be noted that the side surface of the insulating heat conduction member 32 that faces away from the electrical component 31 being flush with a groove opening of the second limiting structure 342 means that when the insulating heat conduction member 32 is embedded in the second limiting structure 342, the side surface of the insulating heat conduction member 32 that faces away from the electrical component 31 is neither concave with respect to the groove opening of the second limiting structure 342 nor convex with respect to the groove opening of the second limiting structure 342, but instead is flush with the groove opening of the second limiting structure 342. With such an arrangement, the side surface of the insulating heat conduction member 32 that faces away from the electrical component 31 can protrude from the second limiting structure 342, and is directly thermally connected to the heat exchange member 40.

Through the use of the foregoing solution, in a case that the insulating heat conduction member 32 is embedded in the second limiting structure 342, the side surface of the insulating heat conduction member 32 that faces away from the electrical component 31 may be flush with the groove opening of the second limiting structure 342, so that the side surface of the insulating heat conduction member 32 that faces away from the electrical component 31 can be exposed from the second limiting structure 342. Based on this, the side surface of the insulating heat conduction member 32 that faces away from the electrical component 31 may be directly thermally connected to the heat exchange member 40, so that the obstruction of a heat conduction path between the insulating heat conduction member 32 and the heat exchange member 40 by the base 34 can be reduced, and the heat conduction between the insulating heat conduction member 32 and the heat exchange member 40 can be ensured and enhanced.

Certainly, in other embodiments, the side surface of the insulating heat conduction member 32 that faces away from the electrical component 31 may be concave in the groove opening of the second limiting structure 342, and is thermally connected to the heat exchange member 40 through a heat conduction pad or another heat conduction structure.

Referring to FIG. 5, FIG. 6, and FIG. 8, in some embodiments of this application, the insulating heat conduction member 32 and the base 34 are an integrally formed structure.

It should be noted that the insulating heat conduction member 32 and the base 34 may form an integrally formed structure by, but not limited to, integral injection molding, 3D printing, or another integral molding process.

Through the use of the foregoing solution, the insulating heat conduction member 32 and the base 34 may form an integrally formed structure by integral injection molding, 3D printing, or another integral molding process. Based on this, the connection reliability, the connection tightness, the connection stability, and the connection strength between the insulating heat conduction member 32 and the base 34 can be effectively enhanced, thereby effectively enhancing the combined structural strength of the insulating heat conduction member 32 and the base 34, simplifying the assembly procedure of the insulating heat conduction member 32 and the base 34, and enhancing the assembly convenience and assembly efficiency between the insulating heat conduction member 32 and the base 34. In addition, through the arrangement in this embodiment, the insulating heat conduction member 32 and the base 34 can further be integrally connected and hermetically connected, so that a connection gap between the insulating heat conduction member 32 and the base 34 can be conveniently, quickly, and reliably sealed, thereby enhancing the sealing performance between the insulating heat conduction member 32 and the base 34, and reducing a risk of high-voltage short circuit arcing because liquid leaks to the electrical component 31 through the connection gap between the insulating heat conduction member 32 and the base 34.

Certainly, in other embodiments, the insulating heat conduction member 32 and the base 34 may be first detachably formed and then detachably connected, or even, the connection structure between the insulating heat conduction member 32 and the base 34 may be designed, or a sealing ring, sealant, or another element may be used, thereby ensuring the sealing performance between the insulating heat conduction member 32 and the base 34. The detachable connection manner between the insulating heat conduction member 32 and the base 34 may use a variety of designs, for example, a snap-fit clip, bonding, and secure fastening with a bolt.

Referring to FIG. 5, FIG. 6, and FIG. 8, in some embodiments of this application, a direct current breakdown strength of the insulating heat conduction member 32 ranges from 15 Kv/mm to 17 Kv/mm.

It should be noted that the direct current breakdown strength of the insulating heat conduction member 32 represents a voltage withstand capability of the insulating heat conduction member 32, indicating that the insulating heat conduction member 32 is not prone to breakdown or damage to lose insulation when bearing an electric field strength less than the direct current breakdown strength.

A direct current electric field may be applied through the insulating heat conduction member 32, the voltage is gradually increased, and when the insulating heat conduction member 32 loses insulation due to breakdown or damage, based on an electric field strength that the insulating heat conduction member 32 bears, "the direct current breakdown strength of the insulating heat conduction member 32" is obtained. For example, in a specific embodiment, the insulating heat conduction member 32 may be placed between a grounding electrode and a high-voltage electrode, and the grounding electrode and the high-voltage electrode with the insulating heat conduction member 32 sandwiched therebetween is immersed in an oil tank filled with silicon oil or the like, and a direct current power supply is connected to the grounding electrode and the high-voltage electrode. Subsequently, the oil in the oil tank is heated to a predetermined measurement temperature, and the predetermined measurement temperature may correspond to a temperature of the insulating heat conduction member 32 during actual operation. Subsequently, when the insulating heat conduction member 32 is heated to the predetermined measurement temperature, the direct current power supply applies the direct current electric field to the insulating heat conduction member 32 between the grounding electrode and the high-voltage electrode. Subsequently, the voltage is gradually increased, and when the insulating heat conduction member 32 loses insulation due to breakdown or damage, the electric field strength applied by the direct current power supply is the measured "direct current breakdown strength of the insulating heat conduction member 32".

In this embodiment, the direct current breakdown strength of the insulating heat conduction member 32 is not less than 15 Kv/mm, i.e., the direct current breakdown strength of the insulating heat conduction member 32 is greater than or equal to 15 Kv/mm. In addition, the direct current breakdown strength of the insulating heat conduction member 32 is not greater than 17 Kv/mm, i.e., the direct current breakdown strength of the insulating heat conduction member 32 is less than or equal to 17 Kv/mm. For example, the direct current breakdown strength of the insulating heat conduction member 32 may be 15 Kv/mm, 15.5 Kv/mm, 16 Kv/mm, 16.5 Kv/mm, 17 Kv/mm, or the like. In other words, the insulating heat conduction member 32 is not prone to breakdown and damage to lose insulation when bearing an electric field strength of 15 Kv/mm to 17 Kv/mm.

Through the use of the foregoing solution, the direct current breakdown strength of the insulating heat conduction member 32 ranges from 15 Kv/mm to 17 Kv/mm, so that the insulating heat conduction member 32 can have a better voltage withstand capability with respect to a conventional insulating thermally conductive adhesive. Based on this, based on reliable heat exchange and heat conduction of the insulating heat conduction member 32 between the electrical component 31 and the heat exchange member 40 (not shown in FIG. 3), a risk of high-voltage breakdown of the insulating heat conduction member 32 during the operation of the electrical component 31 can be effectively reduced, thereby effectively ensuring and prolonging the service life of the insulating heat conduction member 32, effectively reducing a risk of thermal failure of the electrical component 31, and effectively ensuring and enhancing the service life and the use safety of the power distribution apparatus 30.

Referring to FIG. 5, FIG. 6, and FIG. 8, in some embodiments of this application, a direct current breakdown strength of the insulating heat conduction member 32 ranges from 15.1 Kv/mm to 16.6 Kv/mm.

It should be noted that the direct current breakdown strength of the insulating heat conduction member 32 ranges from 15.1 Kv/mm to 16.6 Kv/mm. For example, the direct current breakdown strength of the insulating heat conduction member 32 may be 15.1 Kv/mm, 15.2 Kv/mm, 15.3 Kv/mm, 15.4 Kv/mm, 15.5 Kv/mm, 15.6 Kv/mm, 15.7 Kv/mm, 15.8 Kv/mm, 15.9 Kv/mm, 16.0 Kv/mm, 16.1 Kv/mm, 16.2 Kv/mm, 16.3 Kv/mm, 16.4 Kv/mm, 16.5 Kv/mm, 16.6 Kv/mm, or the like.

Through the use of the foregoing solution, the direct current breakdown strength of the insulating heat conduction member 32 ranges from 15.1 Kv/mm to 16.6 Kv/mm, so that in one aspect, the insulating heat conduction member 32 can have a better voltage withstand capability compared with a conventional insulating thermally conductive adhesive, so that a risk of high-voltage breakdown of the insulating heat conduction member 32 during the operation of the electrical component 31 can be effectively reduced, thereby effectively ensuring and prolonging the service life of the insulating heat conduction member 32, effectively reducing a risk of thermal failure of the electrical component 31, and effectively ensuring and enhancing the service life and the use safety of the power distribution apparatus 30. In another aspect, the requirement of the voltage withstand capability of the insulating heat conduction member 32 can be correspondingly measured, thereby effectively reducing the manufacturing difficulty and costs of the insulating heat conduction member 32, and effectively reducing the costs of the power distribution apparatus 30.

Referring to FIG. 5, FIG. 6, and FIG. 8, in some embodiments of this application, the insulating heat conduction member 32 is a phase-change material member.

It should be noted that the insulating heat conduction member 32 is a phase-change material member, i.e., the insulating heat conduction member 32 includes a phase-change material. The phase-change material may be, but is not limited to, a ceramic phase-change material.

Through the use of the foregoing solution, the insulating heat conduction member 32 may be a phase-change material member, so that the insulating heat conduction member 32 can change a substance state and absorb or release a large amount of latent heat based on a phase-change characteristic of a phase-change material as the temperature remains unchanged. Based on this, the heat conduction performance and the heat dissipation performance of the insulating heat conduction member 32 can be effectively ensured and enhanced, thereby effectively ensuring and enhancing the heat dissipation performance and the heat dissipation efficiency of the power distribution apparatus 30 for the electrical component 31, effectively reducing a risk of thermal failure of the electrical component 31, and effectively ensuring and prolonging the service life of the electrical component 31 and the power distribution apparatus 30.

Referring to FIG. 5, FIG. 6, and FIG. 8, in some embodiments of this application, the insulating heat conduction member 32 is a ceramic member.

It should be noted that the insulating heat conduction member 32 is a ceramic member, i.e., the insulating heat conduction member 32 is made of ceramic. The ceramic has excellent heat conduction performance or even has a phase-change characteristic, so that a substance state can be changed and a large amount of latent heat can be absorbed or released based on the phase-change characteristic as the temperature remains unchanged. Based on this, the insulating heat conduction member 32 may be a ceramic member, thereby enhancing the heat conduction performance and the heat dissipation performance of the insulating heat conduction member 32.

The ceramic further has an excellent voltage withstand capability, can withstand a particular electric field strength, and is not prone to breakdown and damage to lose insulation. Based on this, the insulating heat conduction member 32 may be a ceramic member, thereby enhancing the voltage withstand capability of the insulating heat conduction member 32, and can reduce a risk of high-voltage breakdown of the insulating heat conduction member 32 during the operation of the electrical component 31.

Through the use of the foregoing solution, the insulating heat conduction member 32 is a ceramic member, so that in one aspect, the heat conduction performance and the heat dissipation performance of the insulating heat conduction member 32 can be effectively enhanced, thereby effectively enhancing the heat dissipation performance and the heat dissipation efficiency of the power distribution apparatus 30 for the electrical component 31, effectively reducing a risk of thermal failure of the electrical component 31, and effectively ensuring and prolonging the service life of the electrical component 31 and the power distribution apparatus 30. In another aspect, the insulating heat conduction member 32 can have a better voltage withstand capability compared with a conventional insulating thermally conductive adhesive, so that a risk of high-voltage breakdown of the insulating heat conduction member 32 during the operation of the electrical component 31 can be effectively reduced, thereby effectively ensuring and prolonging the service life of the insulating heat conduction member 32, and effectively ensuring and enhancing the service life and the use safety of the power distribution apparatus 30.

Certainly, in other embodiments, the insulating heat conduction member 32 may be another heat conduction material member.

Referring to FIG. 5, FIG. 6, and FIG. 8, in some embodiments of this application, the insulating heat conduction member 32 is at least one selected from the group consisting of aluminum oxide ceramic, aluminum nitride ceramic, and silicon nitride ceramic.

Through the use of the foregoing solution, the insulating heat conduction member 32 may be at least one selected from the group consisting of aluminum oxide ceramic, aluminum nitride ceramic, and silicon nitride ceramic, so that the insulating heat conduction member 32 has excellent performance such as electrical insulativity, heat conductivity, chemical resistance, abrasive resistance, and low thermal expansibility, thereby enhancing the use performance and the service life of the insulating heat conduction member 32.

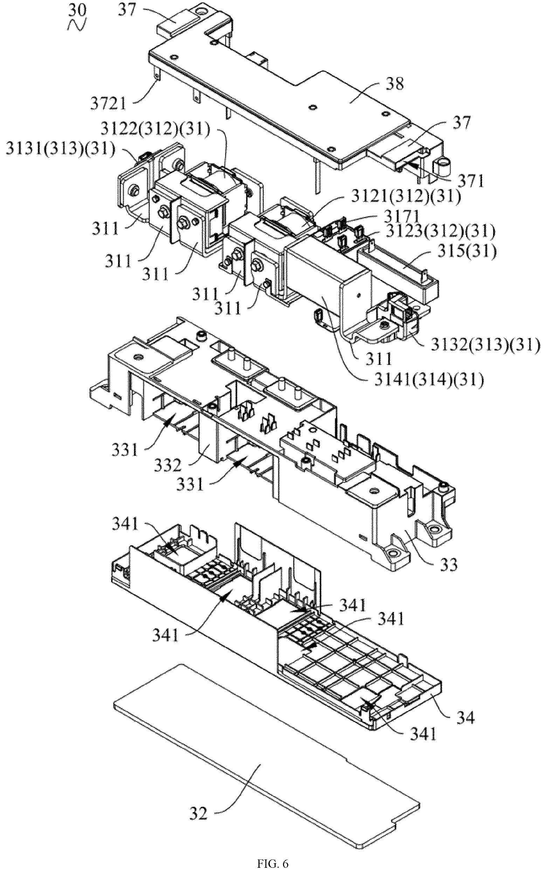

Referring to FIG. 5 and FIG. 6, in some embodiments of this application, at least two electrical components 31 are provided, one insulating heat conduction member 32 is provided, and all the electrical components 31 are thermally connected to the insulating heat conduction member 32.

It should be noted that at least two electrical components 31 are provided. The at least two electrical components 31 include one or at least two of the relay 312, the current sensor 313, the fuse, the protection device 314, and the pre-charge resistor 315.

One insulating heat conduction member 32 is provided. All the electrical components 31 are connected to one same insulating heat conduction member 32 with thermal insulation, that is, the insulating heat conduction member 32 may achieve heat conduction for the at least two electrical components 31.

Through the use of the foregoing solution, the at least two electrical components 31 may all be thermally connected to the insulating heat conduction member 32, so that the insulating heat conduction member 32 can achieve heat conduction on the at least two electrical components 31. Based on this, in one aspect, an arrangement area of the insulating heat conduction member 32 can be increased, and the heat conduction of the insulating heat conduction member 32 for the electrical components 31 can be ensured and enhanced, thereby ensuring and enhancing the heat dissipation performance and the heat dissipation efficiency of the power distribution apparatus 30 for the electrical component 31, reducing a risk of thermal failure of the electrical component 31, and ensuring and prolonging the service life of the electrical component 31 and the power distribution apparatus 30. In another aspect, an arrangement quantity of the insulating heat conduction members 32 can be reduced, so that the assembly of the insulating heat conduction member 32 is simplified, thereby ensuring and enhancing the assembly convenience and the assembly efficiency of the power distribution apparatus 30.

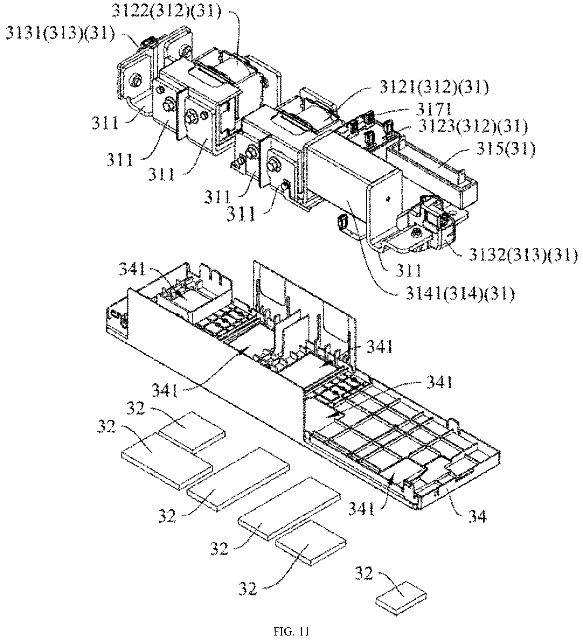

Referring to FIG. 4 and FIG. 11, in some embodiments of this application, the insulating heat conduction member 32 is disposed in a one-to-one correspondence with the electrical component 31.

It should be noted that one or at least two electrical components 31 are provided. The electrical component 31 includes at least one of the relay 312, the current sensor 313, the fuse, the protection device 314, and the pre-charge resistor 315.

The arrangement quantity of the insulating heat conduction members 32 corresponds to the arrangement quantity of the electrical components 31, so that the insulating heat conduction members 32 can be connected to the electrical components 31 with thermal insulation in a one-to-one correspondence, i.e., the insulating heat conduction members 32 can achieve heat conduction for the electrical components 31 in a one-to-one correspondence.

Through the use of the foregoing solution, the insulating heat conduction member 32 and the electrical component 31 may be disposed in a one-to-one correspondence, so that the insulating heat conduction members 32 can be connected in a one-to-one correspondence to the electrical components 31 with thermal insulation, thereby enabling the insulating heat conduction members 32 to achieve heat conduction for the electrical components 31 in a one-to-one correspondence. Based on this, the heat conduction of the insulating heat conduction members 32 for the electrical components 31 can be respectively ensured, or even the dimensions and shape of a corresponding insulating heat conduction member 32 can be designed in a targeted manner according to a heat conduction demand of an electrical component 31. In this way, the heat dissipation performance and the heat dissipation efficiency of the power distribution apparatus 30 for the electrical component 31 can be effectively ensured and enhanced, thereby reducing a risk of thermal failure of the electrical component 31, and ensuring and prolonging the service life of the electrical component 31 and the power distribution apparatus 30. In addition, based on the arrangement in this embodiment, the total material consumption of the insulating heat conduction members 32 can further be correspondingly reduced, thereby correspondingly reducing the overall costs of the insulating heat conduction members 32, and correspondingly reducing the costs of the power distribution apparatus 30

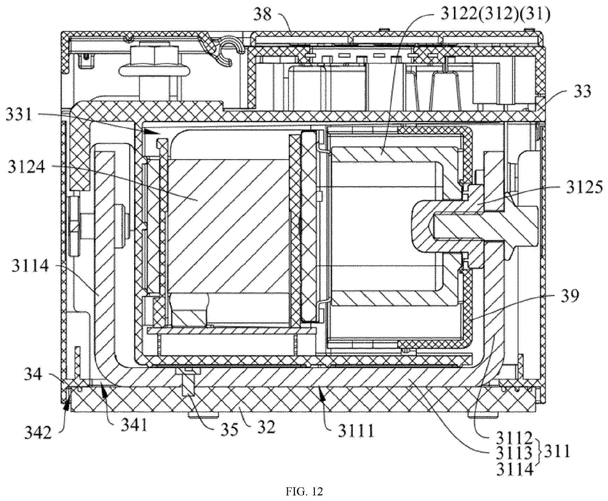

Referring to FIG. 4 and FIG. 12, in some embodiments of this application, the insulating heat conduction member 32 is securely fastened to the electrical component 31 by a fastening member 35.

It should be noted that the electrical component 31 and the insulating heat conduction member 32 may be securely fastened together by one or at least two fastening members 35, thereby enhancing the connection strength and the connection tightness between the electrical component 31 and the insulating heat conduction member 32. The fastening member 35 may be, but is not limited to, a bolt.

Through the use of the foregoing solution, the electrical component 31 and the insulating heat conduction member 32 may be securely fastened together by the fastening member 35, thereby enhancing the connection strength and the connection tightness between the electrical component 31 and the insulating heat conduction member 32. Based on this, the tightness and reliability of the thermal connection between the electrical component 31 and the insulating heat conduction member 32 can be enhanced, so that the insulating heat conduction member 32 can reliably and effectively conduct heat generated by the electrical component 31 to the heat exchange member 40. In this way, the heat dissipation performance and the heat dissipation efficiency of the power distribution apparatus 30 for the electrical component 31 can be effectively ensured and enhanced, thereby effectively reducing a risk of thermal failure of the electrical component 31, and effectively ensuring and prolonging the service life of the electrical component 31 and the power distribution apparatus 30.

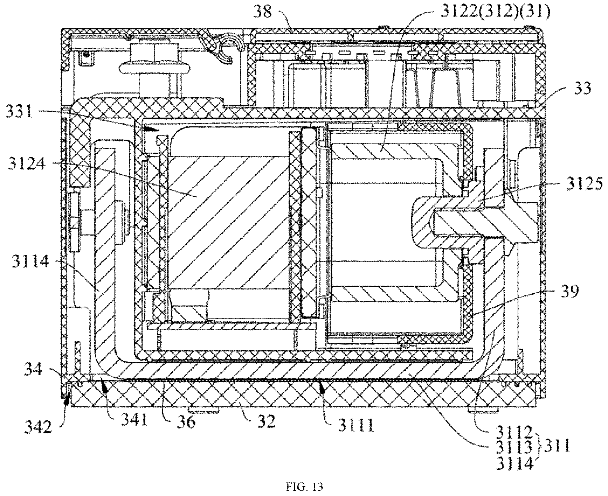

Referring to FIG. 4 and FIG. 13, in some embodiments of this application, the insulating heat conduction member 32 is bonded to the electrical component 31 by a thermally conductive adhesive 36.

It should be noted that the thermally conductive adhesive 36 may be disposed at a connection between the electrical component 31 and the insulating heat conduction member 32, so that the electrical component 31 and the insulating heat conduction member 32 may be bonded together by the thermally conductive adhesive 36, thereby enhancing the connection strength and the connection tightness between the electrical component 31 and the insulating heat conduction member 32.

Through the use of the foregoing solution, the electrical component 31 and the insulating heat conduction member 32 may be bonded together by the thermally conductive adhesive 36, thereby enhancing the connection strength and the connection tightness between the electrical component 31 and the insulating heat conduction member 32. Based on this, the tightness and reliability of the thermal connection between the electrical component 31 and the insulating heat conduction member 32 can be enhanced, so that the insulating heat conduction member 32 can reliably and effectively conduct heat generated by the electrical component 31 to the heat exchange member 40. In this way, the heat dissipation performance and the heat dissipation efficiency of the power distribution apparatus 30 for the electrical component 31 can be effectively ensured and enhanced, thereby effectively reducing a risk of thermal failure of the electrical component 31, and effectively ensuring and prolonging the service life of the electrical component 31 and the power distribution apparatus 30.

Referring to FIG. 6, in some embodiments of this application, the electrical component 31 includes at least one of the relay 312, the current sensor 313, the fuse, the protection device 314, and the pre-charge resistor 315.

It should be noted that the relay 312 is an electrical control component, and is an electrical device that enables a controlled quantity to undergo a predetermined step change in an electric output circuit when a change in an input quantity (an excitation quantity) meets a specified requirement. The relay 312 may include a main positive relay 3121, a main negative relay 3122, a pre-charge relay 3123, and the like.

The current sensor 313 is a detection apparatus, can sense information about a measured current, and can convert detected information according to a particular pattern into an electrical signal that meets a particular standard demand or an information output in another required from, thereby meeting requirements such as transmission, processing, storage, display, recording, and control of information. The current sensor 313 may include a shunt 3131, a Hall current sensor 3132, and the like.

The fuse is an electrical device that disconnects a circuit by melting a fusible body with generated heat when a current exceeds a specified value.

The protection device 314, also referred to as a fuse wire, is a safety component configured to protect the electrical component 31 from damage when a circuit encounters an overload (for example, an overcurrent or an overvoltage), a short circuit, or the like. In some embodiments, the protection device 314 may be used as a fuse.

The pre-charge resistor 315 is a circuit element, configured to limit the magnitude of a charging current in an initial phase of charging (i.e., a power supply charges a capacitor), thereby reducing a risk that the charging current forms a large impact on the relay 312 or another element.

Through the use of the foregoing solution, the electrical component 31 includes at least one selected from the group consisting of the relay 312, the current sensor 313, the fuse, the protection device 314, and the pre-charge resistor 315, so that it can be ensured that the electrical component 31 includes an important element configured to perform high-voltage distribution on the battery 1 in the power distribution apparatus 30, and it can be ensured that the electrical component 31 is a main heat generation element. Based on this, in combination with a connection between the insulating heat conduction member 32 and the electrical component 31 with thermal insulation, the heat dissipation performance and the heat dissipation efficiency of the power distribution apparatus 30 for the electrical components 31 such as the relay 312, the current sensor 313, the fuse, the protection device 314, and the pre-charge resistor 315 can be ensured and enhanced, thereby effectively reducing a risk of thermal failure of the electrical components 31 such as the relay 312, the current sensor 313, the fuse, the protection device 314, and the pre-charge resistor 315, and ensuring and prolonging the service life of the electrical components 31 such as the relay 312, the current sensor 313, the fuse, the protection device 314, and the pre-charge resistor 315.

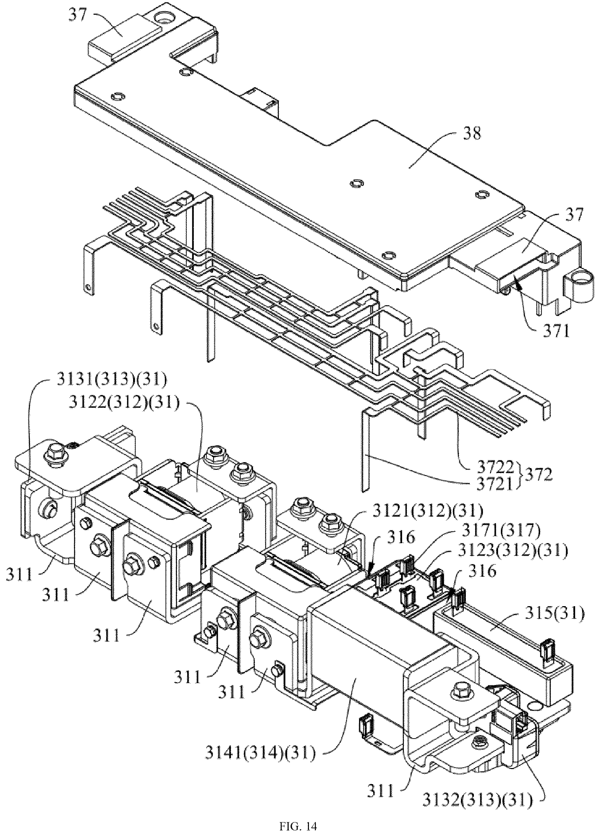

Referring to FIG. 6 and FIG. 14, in some embodiments of this application, at least two electrical components 31 are provided. A gap between the electrical component 31 and the electrical component 31 disposed adjacent to the electrical component 31 is a first gap 316. The electrical component 31 is provided with a first connecting member 317. The first connecting member 317 includes a first connecting portion 3171 configured to be detachably connected to an external connecting member. The first connecting portion 3171 is located outside all the first gaps 316 of the corresponding electrical components 31.

It should be noted that at least two electrical components 31 are provided, and the at least two electrical components 31 may be flexibly arranged. For any electrical component 31, a gap between the electrical component 31 and the electrical component 31 disposed adjacent to the electrical component 31 may be used as the first gap 316. Certainly, for any electrical component 31, when at least two electrical components 31 disposed adjacent to the electrical component 31 are distributed around the electrical component 31, the electrical component 31 may have at least two first gaps 316. The dimensions of the first gaps 316 of the same electrical component 31 may be set to be the same or may be set to be different, and the dimensions of the first gaps 316 of different electrical components 31 may be set to be the same or may be set to be different.

It should further be noted that at least one first connecting member 317 is disposed on the electrical component 31. The first connecting member 317 is configured to be electrically connected to an external connecting member (for example, the first connecting member 317 of another electrical component 31, or a second connecting member 372 hereinafter). One end of the first connecting member 317 is mechanically connected or electrically connected to the electrical component 31, and the first connecting portion 3171 is disposed at the other end of the first connecting member 317. The first connecting portion 3171 is configured to be detachably mechanically connected or electrically connected to the external connecting member. The first connecting portion 3171 may be detachably mechanically connected or electrically connected to the external connecting member by, but not limited to, mating, clipping, and elastic abutting.

The first connecting portion 3171 is located outside all the first gaps 316 of the corresponding electrical components 31. That is, the first connecting portion 3171 is staggered in space from all the first gaps 316 of the corresponding electrical components 31, the first connecting portion 3171 does not occupy a space of the first gaps 316 of the corresponding electrical components 31, and the first connecting portion 3171 is located outside all the first gaps 316 of the corresponding electrical components 31. Based on this, in one aspect, the first connecting portion 3171 may be disposed outside the first gap 316 of the corresponding electrical component 31, so that in one aspect, the connection operation of the first connecting portion 3171 can be performed in a space outside the first gap 316 of the corresponding electrical component 31, thereby ensuring and enhancing the operation convenience of connecting and disconnecting the first connecting portion 3171. In another aspect, the first connecting portion 3171 does not need to be disposed in the first gaps 316 of the corresponding electrical components 31, and a connection operation space does not need to be provided for the first connecting portion 3171. Therefore, the dimensions of the first gaps 316 of the electrical components 31 can be reduced as required, thereby reducing the gap between the electrical component 31 and the electrical component 31 disposed adjacent to the electrical component 31, and making the overall layout of the electrical components 31 compact.

Through the use of the foregoing solution, in a case that the gap between each electrical component 31 and the electrical component 31 disposed adjacent to the electrical component 31 is defined as the first gap 316, the first connecting portion 3171 is disposed outside the first gap 316 of the corresponding electrical component 31, so that in one aspect, the connection operation of the first connecting portion 3171 can be performed in a space outside the first gap 316 of the corresponding electrical component 31, thereby ensuring and enhancing the operation convenience of connecting and disconnecting the first connecting portion 3171. In another aspect, the first gap 316 of the electrical component 31 neither needs to provide an accommodating space for the first connecting portion 3171 nor needs to provide a connection operation space for the first connecting portion 3171, so that the gap between the electrical component 31 and the electrical component 31 disposed adjacent to the electrical component 31 can be reduced as required, thereby making the overall layout of the electrical components 31 compact, and facilitating the formation of the power distribution apparatus 30 featuring integration, compactness, and miniaturization.

Referring to FIG. 6 and FIG. 14, in some embodiments of this application, the power distribution apparatus 30 includes a mating member 37 and a second connecting member 372. The second connecting member 372 includes a conductive connecting portion 3722 and a second connecting portion 3721. One end of the conductive connecting portion 3722 is connected to the mating member 37, and the other end of the conductive connecting portion 3722 is connected to the second connecting portion 3721. The second connecting portion 3721 is bent toward the corresponding electrical component 31, and is configured to be detachably connected to the first connecting portion 3171.

It should be noted that the mating member 37 is a connection terminal configured to be connected to the battery unit 10 (as shown in FIG. 3) or another element. A mounting position and a mounting state of the mating member 37 with respect to the electrical component 31 are stable and secure. The mating member 37 is provided with a mating port 371. The mating port 371 is exposed from the power distribution apparatus 30, so that a connection terminal of the battery unit 10 or another element is mated in the mating port 371 to be electrically connected to the mating member 37.

In some embodiments, two mating members 37 may be disposed in the power distribution apparatus 30. One of the mating members 37 is configured to perform high-voltage sampling, and the other of the mating members 37 is configured to perform low-voltage control. Certainly, in other embodiments, only one mating member 37 may be disposed in the power distribution apparatus 30, and the mating member 37 integrates functions of high-voltage sampling and low-voltage control. Certainly, in other embodiments, three or more mating members 37 may be disposed in the power distribution apparatus 30. The functions of the mating members 37 may be set to be the same or may be set to be different.

It should further be noted that based on a quantity and positions of the electrical components 31 that need to be connected to the mating member 37, one or at least two second connecting members 372 may be disposed on the mating member 37. The second connecting member 372 includes the conductive connecting portion 3722. One end of the conductive connecting portion 3722 is electrically connected to the mating member 37, and the other end of the conductive connecting portion 3722 is disposed extending toward the electrical component 31 to which the conductive connecting portion 3722 is to connect. An extension path of the conductive connecting portion 3722 may be a straight line, a curve, or the like.

At an end of the conductive connecting portion 3722 that is close to the corresponding electrical component 31, the second connecting member 372 may be bent to form the second connecting portion 3721. The conductive connecting portion 3722 and the corresponding second connecting portion 3721 may be integrally connected, or may be detachably connected. The second connecting portion 3721 is bent toward the corresponding electrical component 31, and is configured to be detachably mechanically connected or electrically connected to the first connecting portion 3171 of the corresponding electrical component 31. The second connecting portion 3721 may be detachably mechanically connected or electrically connected to the corresponding first connecting portion 3171 by, but not limited to, mating, clipping, and elastic abutting.

Through the use of the foregoing solution, in a case that the electrical components 31 are mounted in the power distribution apparatus 30, the conductive connecting portion 3722 of the second connecting member 372 may be connected to the mating member 37, and is detachably connected to the first connecting portion 3171 of the corresponding electrical component 31 by the second connecting portion 3721 of the second connecting member 372, thereby conveniently, quickly, and reliably electrically connecting the mating member 37 and the corresponding electrical component 31. Based on this, the mating port 371 of the mating member 37 may be exposed from the power distribution apparatus 30, thereby implementing an electrical connection to the battery unit 10 or another element through the mating port 371. In this way, based on that the elements such as the mating member 37 and the electrical components 31 are integrated and protected on the power distribution apparatus 30, it is convenient to externally connect to the battery unit 10 or another element by the mating member 37, thereby integrating the electrical components 31 and the mating member 37, and providing functions such as high-voltage sampling and low-voltage control to the battery unit 10 or another element.

Referring to FIG. 6 and FIG. 14, in some embodiments of this application, the conductive connecting portion 3722 includes at least one of a conductive sheet, a flexible printed circuit (FPC) board, a printed circuit board (PCB).

It should be noted that the conductive connecting portion 3722 is a portion of the second connecting member 372 that is connected between the mating member 37 and the second connecting portion 3721 of the mating member 37. The conductive connecting portion 3722 may be, but is not limited to, a conductive sheet, an FPC, or a PCB.

Through the use of the foregoing solution, the second connecting member 372 may use the conductive connecting portion 3722 in place of a wiring harness to connect the mating member 37 and the second connecting portion 3721 of the mating member 37, thereby reducing the arrangement of wiring harnesses, reducing problems of wiring harness interference and wiring harness wear, ensuring and enhancing the structural reliability of the mating member 37 and the second connecting member 372, and ensuring the use reliability and use performance of the power distribution apparatus 30.

Referring to FIG. 6, and FIG. 14, in some embodiments of this application, the power distribution apparatus 30 includes a cover body 38. The cover body 38 is connected to the case 33. The mating member 37 is embedded in the cover body 38, and the mating port 371 of the mating member 37 is exposed from the cover body 38. The conductive connecting portion 3722 is embedded in the cover body 38.

It should be noted that the cover body 38 is an element covering the case 33, and has particular structural strength and stiffness. The cover body 38 is connected to a side of the case 33, and is optionally connected to a side of the case 33 that is away from the base 34. A mounting position and a mounting state of the cover body 38 are stable with respect to the case 33. A detachable connection manner or fixed connection manner may be used between the cover body 38 and the case 33.

The cover body 38 and the case 33 may joint define an internal space for mounting at least one electrical component 31. As shown in FIG. 6, in some embodiments, the pre-charge relay 3123 and the pre-charge resistor 315 may be mounted in the space defined by the cover body 38 and the case 33.

It should further be noted that the cover body 38 may be configured to mount and fix the mating member 37 and the second connecting member 372. At least and part of the mating member 37 is embedded in the cover body 38, so that a mounting position and a mounting state of the mating member 37 with respect to the cover body 38 are stable and secure. The mating port 371 of the mating member 37 is exposed from the cover body 38, so that a connection terminal of the battery unit 10 (as shown in FIG. 3) or another element is mated in the mating port 371 to be electrically connected to the mating member 37.At least and part of the conductive connecting portion 3722 of the second connecting member 372 is embedded in the cover body 38, so that a mounting position and a mounting state of the second connecting member 372 with respect to the cover body 38 are stable and secure.

Through the use of the foregoing solution, the cover body 38 may provide adequate protection for the electrical component 31 mounted between the cover body 38 and the case 33, a portion of the mating member 37 that is embedded in the cover body 38, and a portion of the conductive connecting portion 3722 that is embedded in the cover body 38, so that risks of damage to the electrical component 31, the mating member 37, and the conductive connecting portion 3722 can be reduced, thereby extending the service life of the electrical component 31, the mating member 37, and the conductive connecting portion 3722, enhancing the reliability and stability of the electrical connections implemented by the mating member 37 and the second connecting member 372, and enhancing the use reliability and the use safety of the power distribution apparatus 30. In addition, because all the mating member 37 and the second connecting members 372 are fixed and mounted in the cover body 38, during the assembly of the cover body 38, the precise alignment between the second connecting portion 3721 of the second connecting member 372 and the first connecting portion 3171 of the corresponding electrical component 31 can be completed at the same time, and an electrical connection fit between the second connecting portion 3721 and the corresponding first connecting portion 3171 can be completed at the same time, so that assembly steps can be effectively reduced, thereby effectively ensuring and enhancing the connection reliability between the mating member 37 and the electrical component 31, and effectively enhancing the assembly efficiency and the structural reliability of the power distribution apparatus 30.

Referring to FIG. 6 and FIG. 14, in some embodiments of this application, the cover body 38, the mating member 37, and the conductive connecting portion 3722 are an integrally formed structure.

It should be noted that based on the arrangement of "the mating member 37 is embedded in the cover body 38" and "the conductive connecting portion 3722 is embedded in the cover body 38", the cover body 38, the mating member 37, and the conductive connecting portion 3722 may form an integrally formed structure by, but not limited to, integral injection molding, 3D printing, or another integral molding process.

Through the use of the foregoing solution, the cover body 38 and the mating member 37 and the conductive connecting portion 3722 that are embedded in the cover body 38 may form an integrally formed structure by integral injection molding, 3D printing, or another integral molding process. Based on this, the connection reliability, the connection tightness, the connection stability, and the connection strength of the cover body 38 and the mating member 37 and the conductive connecting portion 3722 can be effectively enhanced, thereby effectively enhancing the combined structural strength of the cover body 38 and the mating member 37 and the conductive connecting portion 3722, effectively enhancing the protection of the mating member 37 and the conductive connecting portion 3722 by the cover body 38, reducing a risk of wear or damage to the mating member 37, and reducing a risk of interference, damage, or the like to the conductive connecting portion 3722.

In addition, based on the arrangement of this embodiment, assembly procedures between the cover body 38 and the mating member 37 and between the cover body 38 and the conductive connecting portion 3722 can further be simplified, and during the assembly of the cover body 38, the precise alignment between the second connecting portion 3721 of the second connecting member 372 and the first connecting portion 3171 of the corresponding electrical component 31 are further completed at the same time, and an electrical connection fit between the second connecting portion 3721 and the corresponding first connecting portion 3171 are completed at the same time, so that assembly steps can be effectively reduced, i.e., the connection procedure between the second connecting member 372 and the electrical component 31 can be simplified, thereby effectively ensuring and enhancing the connection reliability between the mating member 37 and the electrical component 31, and effectively enhancing the assembly efficiency and the structural reliability of the power distribution apparatus 30.

Referring to FIG. 4 to FIG. 9 and FIG. 14, in combination with some foregoing embodiments, embodiments of this application provide a specific example of the power distribution apparatus 30.

The power distribution apparatus 30 includes the insulating heat conduction member 32 and the base 34. The base 34 is disposed on the heat exchange member 40 (as shown in FIG. 3). One second limiting structure 342 is disposed on a side of the base 34 that faces the heat exchange member 40. One insulating heat conduction member 32 is provided, is embedded in the second limiting structure 342, and is integrally formed with the base 34. A side surface of the insulating heat conduction member 32 that faces the heat exchange member 40 protrudes from the groove opening of the second limiting structure 342, and is thermally connected to the heat exchange member 40.

The power distribution apparatus 30 includes the case 33 and the electrical component 31. The case 33 is mounted on the side of the base 34 that faces away from the heat exchange member 40. The electrical component 31 is mounted on the case 33. The conductive structure 311 is disposed on the electrical component 31. The conductive structure 311 includes a first conductive portion 3112, a second conductive portion 3113, and a third conductive portion 3114. The first conductive portion 3112 is connected to the corresponding electrical component 31, and is disposed extending toward a side close to the base 34. The third conductive portion 3114 is connected to the corresponding electrical element, and is disposed extending toward the side close to the base 34. The second conductive portion 3113 is bent and connected to an end of the first conductive portion 3112 that is close to the base 34 and an end of the third conductive portion 3114 that is close to the base 34. The second conductive portion 3113 is disposed on the side of the case 33 that faces the base 34. The first limiting structure 341 is disposed on a side of the base 34 that faces the case 33. The first limiting structure 341 is a hole structure. The first limiting structure 341 is in communication with a groove bottom of the second limiting structure 342. The second conductive portion 3113 of the electrical component 31 is limited in the corresponding first limiting structure 341. The heat conduction surface 3111 is disposed on a side surface of the second conductive portion 3113 that is close to the insulating heat conduction member 32. The heat conduction surface 3111 is connected to the surface of the insulating heat conduction member 32 that corresponds to the first limiting structure 341 with thermal insulation.

Based on this, during the operation of the electrical component 31, the insulating heat conduction member 32 can conduct heat generated by the electrical component 31, especially the conductive structure 311, to the heat exchange member 40, so that the heat of the electrical component 31 is quickly conducted outside the power distribution apparatus 30, thereby enhancing the heat dissipation performance and the heat dissipation efficiency of the power distribution apparatus 30 for the electrical component 31, reducing a risk of thermal failure of the electrical component 31, and ensuring and prolonging the service life of the power distribution apparatus 30. The insulating heat conduction member 32 uses a ceramic member with excellent heat conduction performance and an excellent voltage withstand capability, so that the insulating heat conduction member 32 can reliably achieve heat conduction and also reduce a risk of high-voltage breakdown of the insulating heat conduction member 32 during the operation of the electrical component 31, thereby ensuring and prolonging the service life of the insulating heat conduction member 32, and ensuring and enhancing the service life and the use safety of the power distribution apparatus 30.

Two accommodating cavities 331 are provided on a circumferential side (i.e., any side adjacent to a side of the case 33 that faces the base 34) of the case 33. At least two electrical components 31 are provided. The at least two electrical components 31 include the main positive relay 3121 and the main negative relay 3122. The main positive relay 3121 is fixed and mounted in one of the accommodating cavities 331. The main positive relay 3121 is an unhoused relay 312. The outer wall of the switch unit 3124 of the main positive relay 3121 is exposed from the accommodating cavity 331. The wall of the accommodating cavity 331 is connected to the main positive relay 3121, so that the main positive relay 3121 is fixed in the accommodating cavity 331. The main negative relay 3122 is fixedly disposed in the other accommodating cavity 331. The main negative relay 3122 is an unhoused relay 312. The outer wall of the switch unit 3124 of the main negative relay 3122 is exposed from the accommodating cavity 331. The wall of the accommodating cavity 331 is connected to the main negative relay 3122, so that the main negative relay 3122 is fixed in the accommodating cavity 331. Based on this, based on accommodating, limiting, fixing, and protecting the main positive relay 3121 and the main negative relay 3122 by the case 33, the casing structures of the main positive relay 3121 and the main negative relay 3122 can be omitted, so that the layout of the power distribution apparatus 30 can be compact, the design margins, space waste, and an occupied space of the power distribution apparatus 30 can be reduced, the mass of the power distribution apparatus 30 can be reduced, the power distribution apparatus 30 featuring integration, miniaturization, lightweight, and simplicity can be formed, and the production costs of the power distribution apparatus 30 can be reduced. The conductive structure 311 of the relay 312 is disposed outside the accommodating cavity 331 without additionally occupying an internal space of the accommodating cavity 331. Particularly, the second conductive portion 3113 of the conductive structure 311 of the relay 312 is disposed on the outer side of the accommodating cavity 331 that is close to the insulating heat conduction member 32, so that the conductive structure 311 of the relay 312 can be directly connected to the insulating heat conduction member 32 with thermal insulation by the second conductive portion 3113. To facilitate the connection of the wall of the accommodating cavity 331 to the relay 312, a cover member 39 is disposed on the power distribution apparatus 30. The cover member 39 and the relay 312 is in a sleeved fit. Snap-fit clips 391 are disposed on two opposite sides of the cover member 39. The snap-fit clips 391 are snap-fitted to the wall of the accommodating cavity 331. The cover member 39 is provided with a through hole 392 provided corresponding to the contact 3125 of the relay 312, and the contact 3125 is exposed from the corresponding through hole 392, thereby facilitating the connection of the contact 3125 to the high-voltage circuit.

The two accommodating cavities 331 are disposed adjacently, i.e., are disposed close to each other. The insulating structure 332 is provided in the case 33. The insulating structure 332 is disposed between the two accommodating cavities 331. The insulating structure 332 may insulate the two accommodating cavities 331, particularly, may insulate the main positive relay 3121 and the main negative relay 3122, particularly, may insulate the contact 3125 of the main positive relay 3121 and the contact 3125 of the main negative relay 3122. Based on this, the insulativity between the contact 3125 of the main positive relay 3121 and the contact 3125 of the main negative relay 3122 can be effectively enhanced, so that a short circuit risk can be reduced, thereby enhancing the use reliability and the use safety of the power distribution apparatus 30.

The electrical components 31 further include the pre-charge relay 3123, the shunt 3131, the Hall current sensor 3132, a main protection device 3141, and the pre-charge resistor 315. The pre-charge relay 3123 is disposed on a side of the main positive relay 3121 that faces away from the main negative relay 3122, and is disposed close to the main positive relay 3121. The pre-charge resistor 315 is disposed on a side of the pre-charge relay 3123 that faces away from the main positive relay 3121, and is disposed close to the pre-charge relay 3123. The main protection device 3141 is disposed on the side of the main positive relay 3121 that faces away from the main negative relay 3122, and is disposed adjacent to both the pre-charge relay 3123 and the pre-charge resistor 315. The main protection device 3141 is disposed close to the main positive relay 3121, the pre-charge relay 3123, and the pre-charge resistor 315. Both the shunt 3131 and the Hall current sensor 3132 are current sensors 313. The Hall current sensor 3132 is disposed on a side of the main protection device 3141 that faces away from the main positive relay 3121. The shunt 3131 is disposed on the side of the main positive relay 3121 that faces away from the main negative relay 3122. The main positive relay 3121, the main negative relay 3122, the pre-charge relay 3123, the shunt 3131, the Hall current sensor 3132, a main protection device 3141, and the pre-charge resistor 315 establish corresponding to electrical connection relationships according to the circuit principle diagram of the power distribution apparatus 30. The circuit principle diagram of the power distribution apparatus 30 is a technology well known to a person skilled in the art, and details are not described herein again. Based on this, for the main positive relay 3121, the main negative relay 3122, the pre-charge relay 3123, the shunt 3131, the Hall current sensor 3132, a main protection device 3141, and the pre-charge resistor 315, the compact and optimized layout can be implemented, the design margins, space waste, and an occupied space of the power distribution apparatus 30 can be reduced, the dimension of the power distribution apparatus 30 in the direction perpendicular to the base 34 can be reduced, and the overall dimensions of the power distribution apparatus 30 can be reduced, thereby forming the power distribution apparatus 30 featuring integration and miniaturization.

The power distribution apparatus 30 further includes the cover body 38. The cover body 38 is disposed on the side of the case 33 that is away from the base 34. The cover body 38, the case 33, and the base 34 may cooperate to define the internal space of the case 33. Based on the compact layout of the electrical components 31, the case 33 and the base 34 define one internal space to accommodate the main protection device 3141. The case 33 and the cover body 38 define another internal space to accommodate the pre-charge relay 3123 and the pre-charge resistor 315. The main positive relay 3121 and the main negative relay 3122 are mounted in the two accommodating cavities 331 of the case 33 in a one-to-one correspondence.

The first connecting member 317 is disposed on each of the electrical component 31. The first connecting member 317 is provided with the first connecting portion 3171 configured to be detachably electrically connected to the second connecting member 372 of the mating member 37. For any electrical component 31, a gap between the electrical component 31 and the electrical component 31 disposed adjacent to the electrical component 31 may be used as the first gap 316. The first connecting portion 3171 of the first connecting member 317 disposed on the electrical component 31 is located outside the first gap 316 of the electrical component 31. The pre-charge relay 3123 is used as an example. The main positive relay 3121, the pre-charge resistor 315, the main protection device 3141, and the pre-charge relay 3123 are disposed adjacently. A gap between the main positive relay 3121 and the pre-charge relay 3123, a gap between the pre-charge resistor 315 and the pre-charge relay 3123, and a gap between the main protection device 3141 and the pre-charge relay 3123 may all be used as the first gaps 316. However, the dimensions of these first gaps 316 may be set to be the same or may be set to be different. The first connecting portion 3171 of the first connecting member 317 disposed for the pre-charge relay 3123 may be disposed outside the first gaps 316 of the pre-charge relay 3123, that is, the first connecting portion 3171 disposed for the pre-charge relay 3123 may be disposed outside the gap between the main positive relay 3121 and the pre-charge relay 3123, and may also be disposed outside the gap between the pre-charge resistor 315 and the pre-charge relay 3123, and may also be disposed outside the gap between the main protection device 3141 and the pre-charge relay 3123. Therefore, in this embodiment, the first connecting portion 3171 of the pre-charge relay 3123 is disposed on a side of the pre-charge relay 3123 that faces the cover body 38. The rest is deduced by analogy. All the respective first connecting portions 3171 of the main positive relay 3121, the main negative relay 3122, the shunt 3131, the Hall current sensor 3132, a main protection device 3141, and the pre-charge resistor 315 may be disposed avoiding the respective first gaps 316 as much as possible. Certainly, according to the layout design demand, for some electrical components 31, the first connecting portions 3171 of the electrical components 31 may be disposed in the first gaps 316 of the electrical components 31. Based on this, the first connecting portion 3171 is disposed outside the first gap 316 of the corresponding electrical component 31, so that in one aspect, the connection operation of the first connecting portion 3171 can be performed in a space outside the first gap 316 of the corresponding electrical component 31, thereby ensuring and enhancing the operation convenience of connecting and disconnecting the first connecting portion 3171. In another aspect, the first gap 316 of the electrical component 31 further neither needs to provide an accommodating space for the first connecting portion 3171 nor needs to provide a connection operation space for the first connecting portion 3171, so that the gap between the electrical component 31 and the electrical component 31 disposed adjacent to the electrical component 31 can be reduced as required, thereby making the overall layout of the electrical components 31 compact, facilitating the formation of the power distribution apparatus 30 featuring integration, compactness, and miniaturization, and enhancing the space utilization and the energy density of the power distribution apparatus 30.

The power distribution apparatus 30 further includes two mating members 37. One of the mating members 37 is configured to be connected to the battery unit 10 to perform high-voltage sampling, and the other of the mating members 37 is configured to be connected to the battery unit 10 to perform low-voltage control. The two mating members 37 are both embedded in the cover body 38, and the mating ports 371 of the two mating member 37 are exposed from the cover body 38. Based on the quantity and positions of the electrical components 31 that need to be connected to the mating member 37, at least one second connecting member 372 is disposed on the mating member 37 as required. One end of the second connecting member 372 is electrically connected to the mating member 37, and the other end of the second connecting member 372 is disposed extending toward the electrical component 31 to which the second connecting member 372 is to connect. An end of the second connecting member 372 that is close to the corresponding electrical component 31 is bent to form the second connecting portion 3721. The second connecting portion 3721 is bent toward the corresponding electrical component 31, and may be configured to be in a detachable mating fit to the first connecting portion 3171 of the corresponding electrical component 31. A mating fit direction of the second connecting portion 3721 and the corresponding first connecting portion 3171 may correspond to an assembly direction of the cover body 38 and the case 33. Based on this, when the assembly between the cover body 38 and the case 33 is completed, the precise alignment between the second connecting portion 3721 and the corresponding first connecting portion 3171 can be completed at the same time, and a mating fit between the second connecting portion 3721 and the corresponding first connecting portion 3171 can be completed at the same time, so that assembly steps can be reduced, thereby ensuring and enhancing the connection reliability between the mating member 37 and the electrical component 31, and enhancing the assembly efficiency and the structural reliability of the power distribution apparatus 30.

The portion of the second connecting member 372 that is connected between the mating member 37 and the second connecting portion 3721 of the mating member 37 is the conductive connecting portion 3722, and the conductive connecting portion 3722 uses a conductive sheet, an FPC, a PCB, or the like in place of a wiring harness, thereby reducing the arrangement of wiring harnesses, reducing problems of wiring harness interference and wiring harness wear, ensuring and enhancing the structural reliability of the mating member 37 and the second connecting member 372, and ensuring the use reliability and use safety of the power distribution apparatus 30. The mating member 37 is embedded in the cover body 38. The conductive connecting portion 3722 is embedded in the cover body 38. The cover body 38, the mating member 37, and the conductive connecting portion 3722 may be integral-injection molded.

Referring to FIG. 3 and FIG. 4, some embodiments of this application provide a battery 1. The battery 1 includes the power distribution apparatus 30 provided in the embodiments of this application.

Through the use of the foregoing solution, the power distribution apparatus 30 provided in the embodiments of this application may be used in the battery 1, thereby ensuring and enhancing the space utilization, the volume utilization, and the energy density of the battery 1.

Referring to FIG. 1, some embodiments of this application provide a power consuming device. The power consuming device includes the battery 1 provided in the embodiments of this application.

Through the use of the foregoing solution, the battery 1 provided in the embodiments of this application may be used in the power consuming device, thereby ensuring and enhancing the use performance of the power consuming device.

The foregoing descriptions are merely preferred embodiments of this application, and are not intended to limit this application. Any modification, equivalent replacement, improvement and the like made within the spirit and principle of this application shall fall within the protection scope of this application.

## Claims

1. A power distribution apparatus, comprising:
an electrical component; and
an insulating heat conduction member, wherein one side of the insulating heat conduction member is connected to at least a part of the electrical component, the other side of the insulating heat conduction member is configured to be connected to a heat exchange member, and the insulating heat conduction member is configured to transfer heat from the electrical component to the heat exchange member.

2. The power distribution apparatus according to claim 1, wherein the electrical component comprises a sheet conductive structure, the conductive structure is provided with a heat conduction surface, and the heat conduction surface is connected to the insulating heat conduction member.

3. The power distribution apparatus according to claim 2, wherein the power distribution apparatus comprises a case, configured to mount the electrical component;
the conductive structure comprises a first conductive portion, a second conductive portion, and a third conductive portion, the second conductive portion is disposed on a side of the case that faces the insulating heat conduction member, and the heat conduction surface is provided on a side of the second conductive portion that faces the insulating heat conduction member; and
the first conductive portion and the third conductive portion are respectively connected to different sides of the second conductive portion, and are both bent toward a side close to the case, the first conductive portion is connected to a corresponding electrical component, and the third conductive portion is configured to be connected to an electrical element.

4. The power distribution apparatus according to claim 3, wherein the case is provided with at least one accommodating cavity;
at least one electrical component is a relay, the relay is fixedly mounted in the accommodating cavity, the relay comprises a switch unit, at least a portion of an outer wall of the switch unit is exposed from the accommodating cavity, and a wall of the accommodating cavity is connected to the relay to fix the relay in the accommodating cavity; and
the conductive structure of the relay is disposed outside the accommodating cavity, and the second conductive portion of the relay is disposed on an outer side of the accommodating cavity that is close to the insulating heat conduction member.

5. The power distribution apparatus according to any one of claims 1 to 4, wherein the power distribution apparatus comprises a base, configured to be disposed on the heat exchange member; and
the insulating heat conduction member is mounted on the base, and a surface of the insulating heat conduction member that faces away from the electrical component is exposed from the base and is connected to the heat exchange member.

6. The power distribution apparatus according to claim 5, wherein the insulating heat conduction member is embedded in the base.

7. The power distribution apparatus according to claim 5 or 6, wherein a first limiting structure is disposed on a side of the base that faces the electrical component, and is configured to limit and mount a portion of the electrical component that is connected to the insulating heat conduction member.

8. The power distribution apparatus according to claim 7, wherein the first limiting structure is a hole structure, and the first limiting structure is in communication with a surface of the insulating heat conduction member.

9. The power distribution apparatus according to any one of claims 5 to 8, wherein a second limiting structure is disposed on a side of the base that faces away from the electrical component, and is configured to limit and mount the insulating heat conduction member.

10. The power distribution apparatus according to claim 9, wherein the second limiting structure is a groove structure, and a side surface of the insulating heat conduction member that faces away from the electrical component is flush with or protrudes from a groove opening of the second limiting structure.

11. The power distribution apparatus according to any one of claims 1 to 10, wherein a direct current breakdown strength of the insulating heat conduction member ranges from 15 Kv/mm to 17 Kv/mm.

12. The power distribution apparatus according to claim 11, wherein the direct current breakdown strength of the insulating heat conduction member ranges from 15.1 Kv/mm to 16.6 Kv/mm.

13. The power distribution apparatus according to any one of claims 1 to 12, wherein the insulating heat conduction member is a phase-change material member; and/or
the insulating heat conduction member is a ceramic member.

14. The power distribution apparatus according to any one of claims 1 to 13, wherein the insulating heat conduction member is at least one selected from the group consisting of aluminum oxide ceramic, aluminum nitride ceramic, and silicon nitride ceramic.

15. The power distribution apparatus according to any one of claims 1 to 14, wherein at least two electrical components are provided, one insulating heat conduction member is provided, and all the electrical components are thermally connected to the insulating heat conduction member.

16. The power distribution apparatus according to any one of claims 1 to 14, wherein the insulating heat conduction member is disposed in a one-to-one correspondence with the electrical component.

17. The power distribution apparatus according to any one of claims 1 to 16, wherein the insulating heat conduction member is securely fastened to the electrical component by a fastening member; and/or
the insulating heat conduction member is bonded to the electrical component by a thermally conductive adhesive.

18. The power distribution apparatus according to any one of claims 1 to 17, wherein the electrical component comprises at least one selected from the group consisting of a relay, a current sensor, a fuse, a protection device, and a pre-charge resistor.

19. The power distribution apparatus according to any one of claims 1 to 18, wherein at least two electrical components are provided; and
a gap between the electrical component and the electrical component disposed adjacent to the electrical component is a first gap, the electrical component is provided with a first connecting member, the first connecting member comprises a first connecting portion configured to be detachably connected to an external connecting member, and the first connecting portion is located outside all the first gaps of the corresponding electrical components.

20. A battery, wherein the battery comprises the power distribution apparatus according to any one of claims 1 to 19.

21. A power consuming device, wherein the power consuming device comprises the battery according to claim 20.
